# EUROPEAN PATENT APPLICATION

(11) **EP 3 587 524 A1**
(43) Date of publication of application: **01.01.2020**
(21) Application number: 19183697.2
(22) Date of filing: 01.07.2019
(51) Int. Cl.: C09G 1/02

(54) **LOW OXIDE TRENCH DISHING CHEMICAL MECHANICAL POLISHING**

(30) Priority: 29.06.2018 US 201862692639 P; 29.06.2018 US 201862692633 P; 24.06.2019 US 201916450753
(71) Applicant: Versum Materials US, LLC, Tempe, AZ 85284 (US)
(72) Inventor: SHI, Xiaobo, Tempe, Arizona 85284 (US); MURELLA, Krishna, P, Tempe, Arizona 85284 (US); ROSE, Joseph, D, Tempe, Arizona 85284 (US); ZHOU, Hongjun, Tempe, Arizona 85284 (US); O'NEILL, Mark, Leonard, Tempe, Arizona 85284 (US)
(74) Representative: Beck Greener LLP

(57) **Abstract**

Chemical mechanical planarization (CMP) polishing compositions, methods and systems are provided to reduce oxide trench dishing and improve over-polishing window stability. High and tunable silicon oxide removal rates, low silicon nitride removal rates, and tunable SiO₂: SiN selectivity are also provided. The compositions use a unique combination of abrasives, such as ceria coated silica particles; and the chemical additives, such as maltitol, lactitol, maltotritol, ribitol, D-sorbitol, mannitol, dulcitol, iditol, D-(-)-Fructose, sorbitan, sucrose, ribose, Inositol, glucose, D-arabinose, L-arabinose, D-mannose, L-mannose, meso-erythritol, beta-lactose, arabinose, or combinations thereof as oxide trench dishing reducing additives.

## Description

### BACKGROUND OF THE INVENTION

This invention relates to chemical mechanical planarization (CMP) for polishing oxide and doped oxide films.

An important step in the fabrication of microelectronics devices is polishing, especially polishing of surfaces bychemical-mechanical polishing for the purpose of recovering a selected material and/or planarizing the structure.

For example, a SiN layer is deposited under a SiO₂ layer to serve as a polish stop. The role of such a polish stop is particularly important in Shallow Trench Isolation (STI) structures. Selectivity is characteristically expressed as the ratio of the oxide polish rate to the nitride polish rate. An example is an increased polishing selectivity rate of silicon dioxide(SiO₂) as compared to silicon nitride(SiN).

In the global planarization of patterned structures, reducing oxide trench dishing is a key factor to be considered. A lower trench oxide loss will prevent electrical current leaking between adjacent transistors. Non-uniform trench oxide loss across die (within Die) will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in CMP polishing compositions.

US Patent 5,876,490 discloses polishing compositions containing abrasive particles and exhibiting normal stress effects. The slurry further contains non-polishing particles resulting in reduced polishing rate at recesses, while the abrasive particles maintain high polish rates at elevations. This leads to improved planarization. More specifically, the slurry comprises cerium oxide particles and polymeric electrolyte, and can be used for Shallow Trench Isolation (STI) polishing applications.

US Patent 6,964,923 teaches the polishing compositions containing cerium oxide particles and polymeric electrolyte for Shallow Trench Isolation (STI) polishing applications. Polymeric electrolytes that areused includes the salts of polyacrylic acid, similar as those in US Patent 5,876,490. Ceria, alumina, silica & zirconia are used as abrasives. Molecular weight for such listed polyelectrolyte is from 300 to 20,000, but in overall, <100,000.

US Patent 6,616,514 discloses a chemical mechanical polishing slurry for use in removing a first substance from a surface of an article in preference to silicon nitride by chemical mechanical polishing. The chemical mechanical polishing slurry according to the invention includes an abrasive, an aqueous medium, and an organic polyol that does not dissociate protons, said organic polyol including a compound having at least three hydroxyl groups that are not dissociable in the aqueous medium, or a polymer formed from at least one monomer having at least three hydroxyl groups that are not dissociable in the aqueous medium.

However, these Shallow Trench Isolation (STI) polishing compositions did not address the importance of reducing oxide trench dishing.

It should be readily apparent from the foregoing that there remains a need within the art for compositions, methods and systems of chemical mechanical polishing that can provide reduced oxide trench dishing and improved over polishing window stability in a chemical and mechanical polishing (CMP) process, in addition to high removal rate of silicon dioxide as well as high selectivity for silicon dioxide to silicon nitride.

### BRIEF SUMMARY OF THE INVENTION

The present invention provides Chemical mechanical polishing(CMP) polishing compositions, methods and systems for a reduced oxide trench dishing and thus improved over polishing window stability by introducing chemical additives as oxide trench dishing reducing additives compositions at wide pH range including acidic, neutral and alkaline pH conditions.

The present invention also provides the benefits of achieving high oxide film removal rates, low SiN film removal rates, high and tunable Oxide: SiN selectivity, lower total defect counts post-polishing, and excellent mean particle size(nm) stability.

In one aspect, there is provided a CMP polishing composition that comprises or consists of:
abrasive particles selected from the group consisting of ceria-coated inorganic oxide particles, ceria-coated organic polymer particles, and combinations thereof;
a chemical additive as oxide trenching dishing reducer,
a solvent; and
optionally a biocide and/or a pH adjuster;
wherein the composition has a pH of 2 to 12, preferably 3 to 10, and more preferably 4 to 9.

Suitable ceria-coated inorganic oxide particles include, but are not limited to, ceria-coated colloidal silica, ceria-coated high purity colloidal silica, ceria-coated alumina, ceria-coated titania, ceria-coated zirconia, or any other ceria-coated inorganic oxide particles. Preferred particles are ceria-coated colloidal silica particles.

Suitable ceria-coated organic polymer particles include, but are not limited to, ceria-coated polystyrene particles, ceria-coated polyurethane particle, ceria-coated polyacrylate particles, or any other ceria-coated organic polymer particles.

Suitable solvent includes but is not limited to deionized (DI) water, distilled water, and alcoholic organic solvents.

The chemical additives used as oxide trenching dishing reducers contain at least two or more, preferably four or more, more preferably six or more hydroxyl functional groups in their molecular structures.

The chemical additive may have a general molecular structure as shown below: 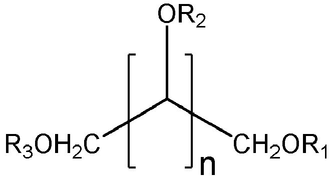 wherein n is selected from 2 to 5,000, preferably from 3 to 12, more preferably from 4 to 7.

R1, R2, and R3 can be the same or different atoms or functional groups.

Each of Rs in the group of R1 to R3 can be independently selected from the group consisting of hydrogen, alkyl, alkoxy, an organic group with one or more hydroxyl groups, a substituted organic sulfonic acid, a substituted organic sulfonic acid salt, a substituted organic carboxylic acid, a substituted organic carboxylic acid salt, an organic carboxylic ester, an organic amine groups, and combinations thereof; wherein, at least two or more, preferably three or four of them are hydrogen atoms.

When R1, R2, and R3 are the same and are hydrogen atoms, the chemical additive bears multi hydroxyl functional groups.

The molecular structures of some examples of such chemical additives are listed below:,

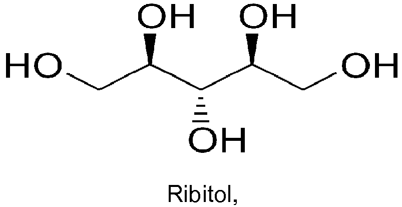

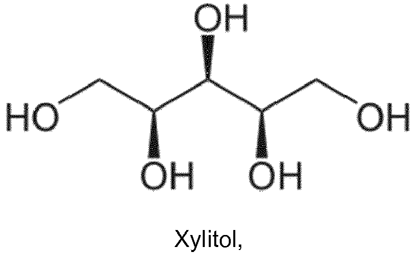

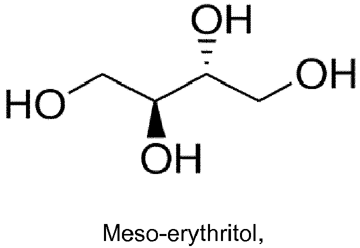

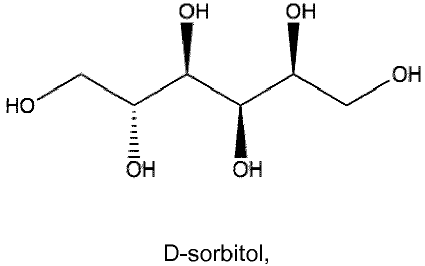

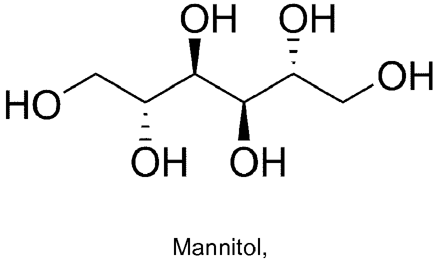

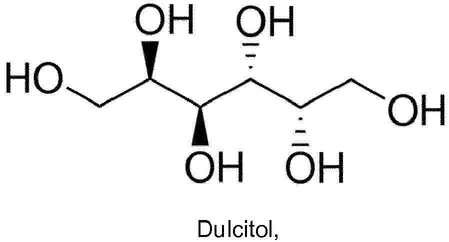

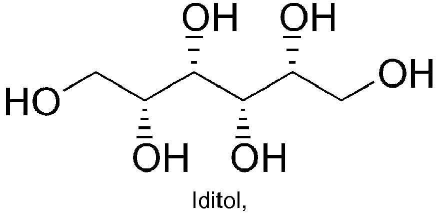

Alternatively, the chemical additive may have a structure shown below:

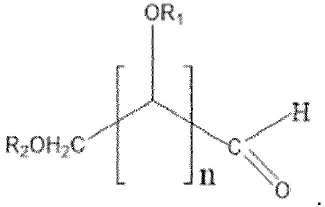

In this structure, one -CHO functional group is located at one end of the molecule as the terminal functional group; n is selected from 2 to 5,000, preferably from 3 to 12, more preferably from 4 to 7.

Each of R1 and R2 can be independently selected from the group consisting of hydrogen, alkyl, alkoxy, organic group with one or more hydroxyl groups, a substituted organic sulfonic acid a substituted organic sulfonic acid salt, a substituted organic carboxylic acid, a substituted organic carboxylic acid salt, an organic carboxylic ester, an organic amine groups, and combinations thereof.

When R1 and R2 are all hydrogen atoms, and n=3, the chemical additive is D-arabinose or L-arabinose:

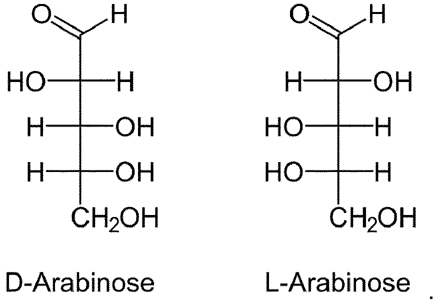

When R1 and R2 are all hydrogen atoms, and n=4, the chemical additive is D-mannose or L-mannose.

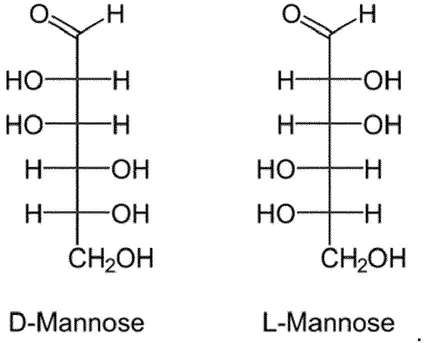

The chemical additive may also have a molecular structure selected from the group comprising of at least one (f), at least one (g), at least one (h) and combinations thereof;

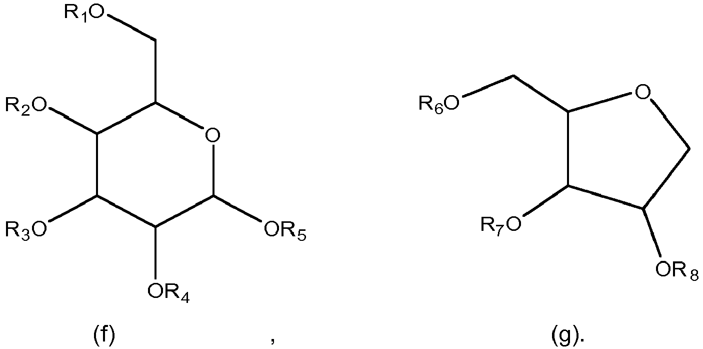

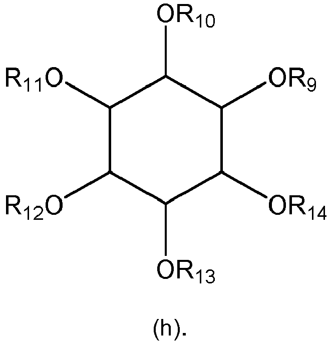

In these general molecular structures; R1, R2, R3, R4, R5, R6, R7, R8, R9, R10, R11, R12, R13, and R14 can be the same or different atoms or functional groups.

R1 to R14 can each be independently selected from the group consisting of hydrogen, alkyl, alkoxy, an organic group with one or more hydroxyl groups, a substituted organic sulfonic acid, substituted organic sulfonic acid salt, a substituted organic carboxylic acid, a substituted organic carboxylic acid salt, an organic carboxylic ester, an organic amine groups, and combinations thereof; wherein, at least two or more, preferably four or more of them are hydrogen atoms.

When R1, R2, R3 R4, R5, R6, R7 R8, R9, R10, R11, R12, R13, and R14 are all hydrogen atoms, chemical additives bearing multi hydroxyl functional groups are provided.

The molecular structures of some examples of such chemical additives are listed below:

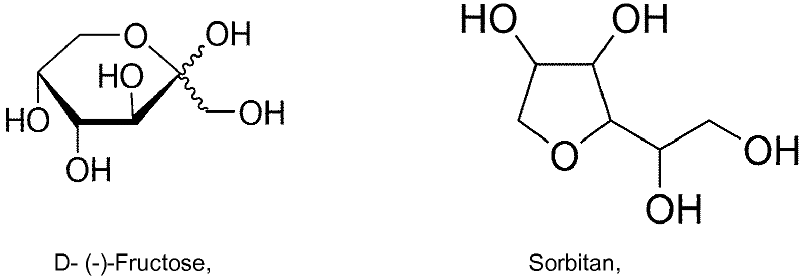

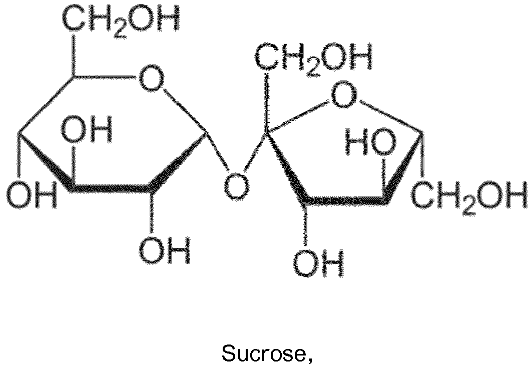

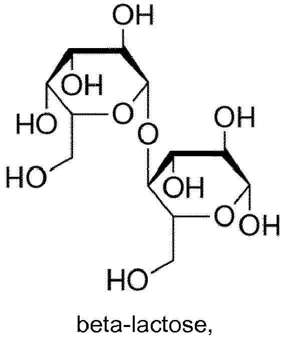

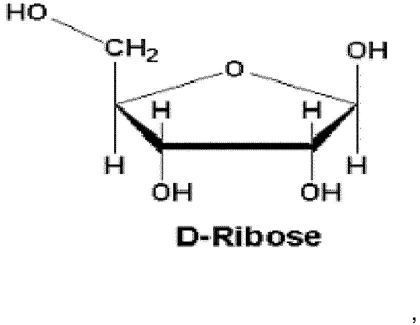

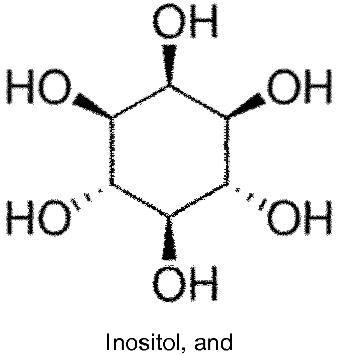

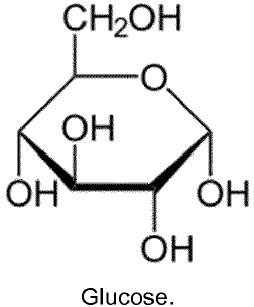

Alternatively the chemical additives contain at least one six-member ring structure motif ether bonded with at least one polyol molecular unit containing multiple hydroxyl functional groups in the molecular unit structures or at least one polyol molecular unit containing multiple hydroxyl functional groups in the molecular unit structures and at least one six-member ring polyol. A polyol is an organic compound containing hydroxyl groups.

The chemical additives as oxide trenching dishing reducers contain at least two, at least four, or at least six hydroxyl functional groups in their molecular structures.

The general molecular structure for the chemical additives is shown in (a):

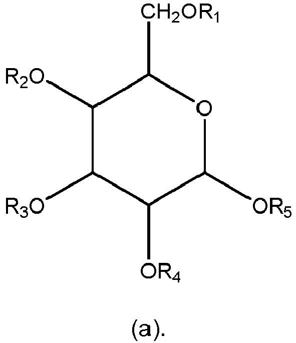

In one embodiment (hereinafter referred to as a first embodiment), at least one R in the group of R1 to R5 in the general molecular structure is a polyol molecular unit having a structure shown in (b): 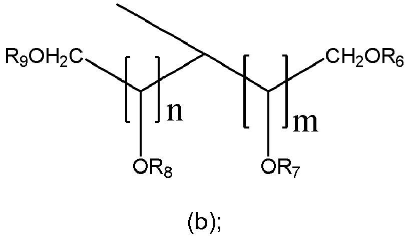 wherein n and m can be the same or different, wherein m and n are each independently selected from 1 to 5, preferably from 1 to 4, more preferably from 1 to 3, and most preferably from 1 to 2. R6 to R9 can be the same or different atoms or functional groups. Each of R6, R7, R8 and R9 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

The rest of Rs in the group of R1 to R5 can be independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

In another embodiment, (hereinafter referred to as a second embodiment) at least one R in the group of R1 to R5 in the general molecular structure is a polyol molecular unit having a structure shown in (b); at least one R in the group of R1 to R5 in the general molecular structure is a six-member ring polyol as shown in (c): 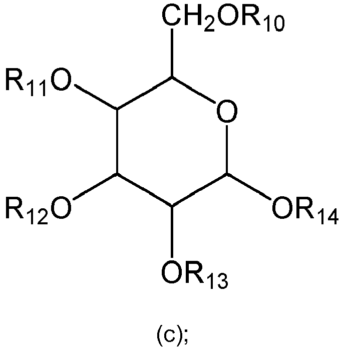
wherein one of OR in group of OR11, OR12, OR13 and OR14 is replaced by O in structure (a); and
R10 and each of other R in group of R10, R11, R12, R13 and R14 is each independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
and the rest of Rs in the group of R1 to R5 can be independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

In the general molecular structure, at least two, preferably four, more preferably six of the Rs in the group of R1 to R9 are hydrogen atoms.

It may be preferred that in the first embodiment only one R, in the group of R1 to R5 in the general molecular structure is a polyol molecular unit (b) having n = 2 and m =1; and all of the rest of the Rs in the group of R1 to R9 are all hydrogen atoms. Where R5 is the polyol molecular unit (b) having n = 2 and m =1 the following two chemical additives are obtained:

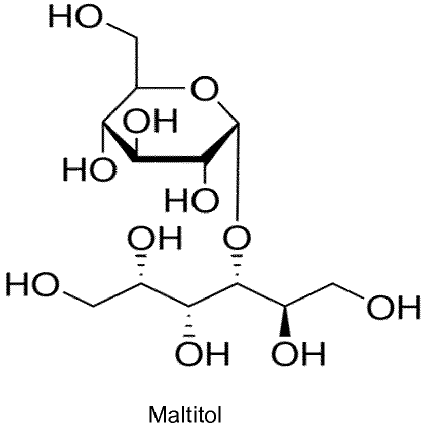

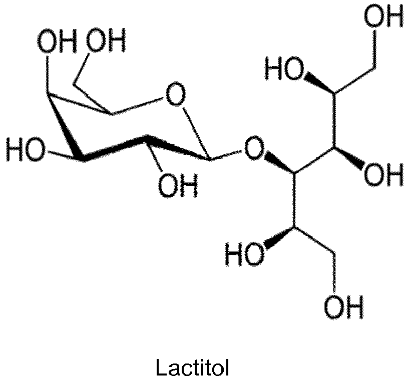

It may be preferred that in the second embodiment one R is a polyol molecular unit (b) having n = 2 and m =1; and one R is a six-member ring polyol; and all of the rest of the Rs in the group of R1 to R14 (other than the R of the OR in the group of OR11 to OR14 that is replaced by O in the structure of (a)) are all hydrogen atoms. Where R5 is the polyol molecular unit (b) having n = 2 and m =1 and R2 is the six-member ring polyol and OR14 is replaced by O in the structure of (a) (specifically, the O in the structure of (a) that is connected to R2), the following chemical additive is obtained:

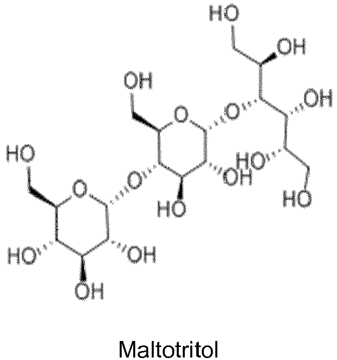

The chemical additive may comprise or consist of maltitol, lactitol, maltotritol, ribitol, D-sorbitol, mannitol, dulcitol, iditol, D- (-)-Fructose, sorbitan, sucrose, ribose, Inositol, glucose, D-arabinose, L-arabinose, D-mannose, L-mannose, meso-erythritol, beta-lactose, arabinose, and combinations thereof. The preferred chemical additives are maltitol, lactitol, maltotritol, D-sorbitol, mannitol, dulcitol, iditol, D- (-)-Fructose, sucrose, ribose, Inositol, glucose. D-(+)-mannose, beta-lactose, and combinations thereof. The more preferred chemical additives are maltitol, lactitol, maltotritol, D-sorbitol, mannitol, dulcitol, D- (-)-Fructose, beta-lactose, or combinations thereof.

The CMP polishing compositions may be made into two or more parts and mixed at the point of use.

In another aspect, there is provided a method of chemical mechanical polishing (CMP) a substrate having at least one surface comprising silicon dioxide (such as for example tetraethyl orthosilicate (TEOS)) using the chemical mechanical polishing (CMP) composition described above.

In yet another aspect, there is provided a system of chemical mechanical polishing (CMP) a substrate having at least one surface comprising silicon dioxide using the chemical mechanical polishing (CMP) composition described above.

The polished oxide films can for example be Chemical vapor deposition (CVD), Plasma Enhance CVD (PECVD), High Density Deposition CVD(HDP), spin on oxide films , flowable CVD oxide film, carbon doped oxide film, or nitrogen doped oxide film.

The substrate disclosed above can further comprises a silicon nitride(SiN) surface. The removal selectivity of SiO₂: SiN is greater than 10, preferably greater than 20, and more preferably greater than 30.

### DETAILED DESCRIPTION OF THE INVENTION

This invention relates to Chemical mechanical polishing(CMP) compositions, methods and systems for polishing oxide and doped oxide films.

In the global planarization of patterned structures, reducing oxide trench dishing is a key factor to be considered. The lower trench oxide loss will prevent electrical current leaking between adjacent transistors. Non-uniform trench oxide loss across die or/and within Die will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in CMP polishing compositions.

The CMP compositions comprise unique combinations of abrasive and the suitable chemical additives.

This invention provides reduced oxide trench dishing and thus improved over polishing window stability by introducing chemical additives as oxide trench dishing reducing additives in the Chemical mechanical polishing(CMP) compositions at wide pH range including acidic, neutral and alkaline pH conditions.

The Chemical Mechanical Polishing (CMP) compositions provide high oxide film removal rates, low SiN film removal rates and high SiO₂: SiN selectivity.

The Chemical Mechanical Polishing (CMP) compositions also further provide excellent mean particle size and size distribution stability for the abrasive particles which is very important in maintaining robust CMP polishing performances with minimized polishing performance variations.

In one aspect, there is provided a CMP polishing composition comprising or consisting of:
abrasive particles selected from the group consisting of ceria-coated inorganic oxide particles, ceria-coated organic polymer particles, and combinations thereof;
chemical additives as oxide trenching dishing reducers,
a solvent; and
optionally a biocide and/or a pH adjuster;
wherein the composition has a pH of 2 to 12, preferably 3 to 10, and more preferably 4 to 9.

The ceria-coated inorganic oxide particles include, but are not limited to, ceria-coated colloidal silica, ceria-coated high purity colloidal silica, ceria-coated alumina, ceria-coated titania, ceria-coated zirconia, or any other ceria-coated inorganic oxide particles.

Suitable ceria-coated organic polymer particles include, but are not limited to, ceria-coated polystyrene particles, ceria-coated polyurethane particle, ceria-coated polyacrylate particles, or any other ceria-coated organic polymer particles.

The average mean particle sizes or mean particle sizes (MPS) of the abrasive particles of the invention described herein are preferably ranged from 2 to 1,000nm, 5 to 500nm, 15 to 400 nm or 25 to 250nm. MPS refers to diameter of the particles and is measured using dynamic light scattering (DLS) technology.

The concentrations of abrasive particles preferably range from 0.01 wt.% to 20 wt.%, the preferred concentrations range from 0.05 wt.% to 10 wt.%, the more preferred concentrations range from 0.1 wt.% to 5 wt.%. As used herein, and unless otherwise indicated, all references to the wt.% of a component of a composition indicate the weight percent of that component by total weight of the composition.

The preferred abrasive particles are ceria-coated inorganic oxide particles; the most preferred abrasive particles are ceria-coated silica particles.

Suitable solvents include but are not limited to deionized (DI) water, distilled water, and alcoholic organic solvents.

The preferred solvent is DI water.

The CMP slurry may for example contain biocide from 0.0001 wt.% to 0.05 wt.%; preferably from 0.0005 wt.% to 0.025 wt.%, and more preferably from 0.001 wt.% to 0.01 wt.%.

Suitable biocide includes, but is not limited to, Kathon™, Kathon™ CG/ICP II, from Dupont/Dow Chemical Co. Bioban from Dupont/Dow Chemical Co. They have active ingredients of 5-chloro-2-methyl-4-isothiazolin-3-one or 2-methyl-4-isothiazolin-3-one.

The CMP slurry may for example contain a pH adjusting agent.

An acidic or basic pH adjusting agent can be used to adjust the polishing compositions to the optimized pH value.

Suitable acidic pH adjusting agents include, but are not limited to nitric acid, hydrochloric acid, sulfuric acid, phosphoric acid, other inorganic or organic acids, and mixtures thereof.

Suitable basic pH adjusting agents, include, but are not limited to sodium hydroxide, potassium hydroxide, ammonium hydroxide, tetraalkyl ammonium hydroxide, organic quaternary ammonium hydroxide compounds, organic amines, and other chemical reagents that can be used to adjust pH towards the more alkaline direction.

The CMP slurry may for example contain 0 wt.% to 1 wt.%; preferably 0.01 wt.% to 0.5 wt.%; more preferably 0.1 wt.% to 0.25 wt.% pH adjusting agent.

The CMP slurry may for example contain 0.01 wt.% to 20 wt.%, 0.025 wt.% to 10 wt.%, 0.05 wt.% to 5 wt.%, or 0.1 to 3.0 wt.% of the chemical additives as oxide trenching dishing and total defect count reducers.

The chemical additives as oxide trenching dishing reducers may for example contain at least two or more, preferably four or more, more preferably six or more hydroxyl functional groups in their molecular structures.

The chemical additive may have a general molecular structure as shown below: 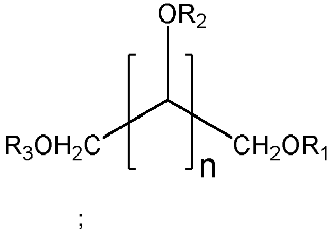
wherein, n is selected from 2 to 5,000, from 3 to 12, preferably from 4 to 7.
R1, R2, and R3 can be the same or different atoms or functional groups.

Each of Rs in the group of R1 to R3 can be independently selected from the group consisting of hydrogen, alkyl, alkoxy, an organic group with one or more hydroxyl groups, a substituted organic sulfonic acid, a substituted organic sulfonic acid salt, a substituted organic carboxylic acid, a substituted organic carboxylic acid salt, an organic carboxylic ester, an organic amine groups, and combinations thereof; wherein, at least two or more, preferably four of them are hydrogen atoms.

When R1, R2, and R3 are the same and are hydrogen atoms, the chemical additive bears multi hydroxyl functional groups.

The molecular structures of some examples of such chemical additives are listed below:

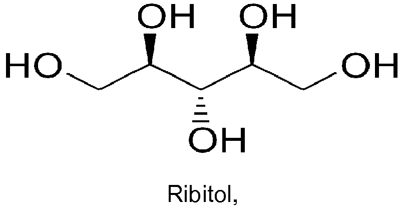

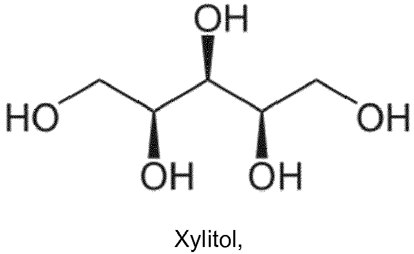

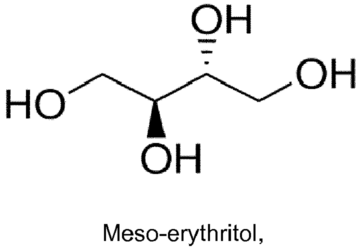

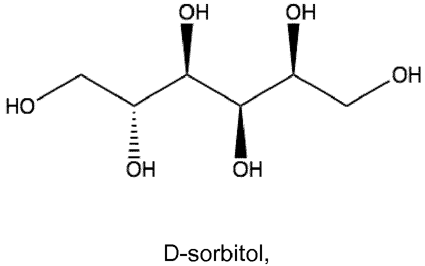

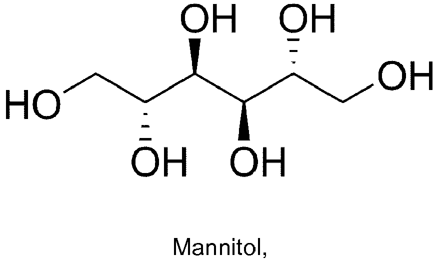

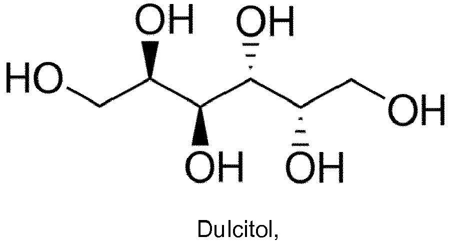

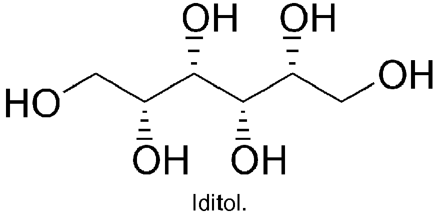

Alternatively, the chemical additive may have a structure shown below:

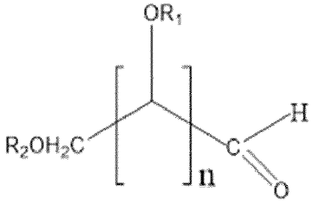

In this structure, one -CHO functional group is located at one end of the molecule as the terminal functional group; and n is selected 2 to 5,000, from 3 to 12, preferably from 4 to 7.

R1 and R2 can be independently selected from the group consisting of hydrogen, alkyl, alkoxy, an organic group with one or more hydroxyl groups, a substituted organic sulfonic acid, a substituted organic sulfonic acid salt, a substituted organic carboxylic acid, a substituted organic carboxylic acid salt, an organic carboxylic ester, an organic amine groups, and combinations thereof.

When R1 and R2 are all hydrogen atoms, and n=3, the chemical additive is D-arabinose or L-arabinose.

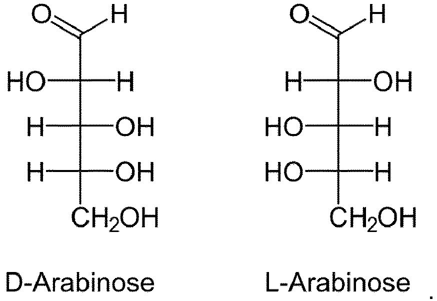

When R1, R2 and R3 are all hydrogen atoms, and n=4, the chemical additive is D-mannose or L-mannose.

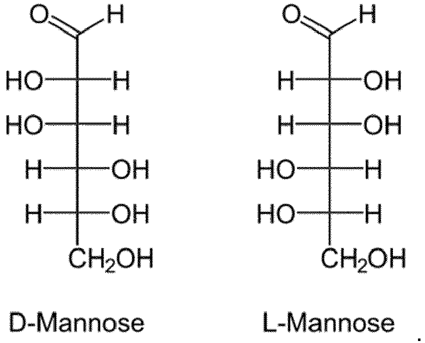

The chemical additive may also have a molecular structure selected from the group comprising of at least one (f), at least one (g), at least one (h) and combinations thereof;

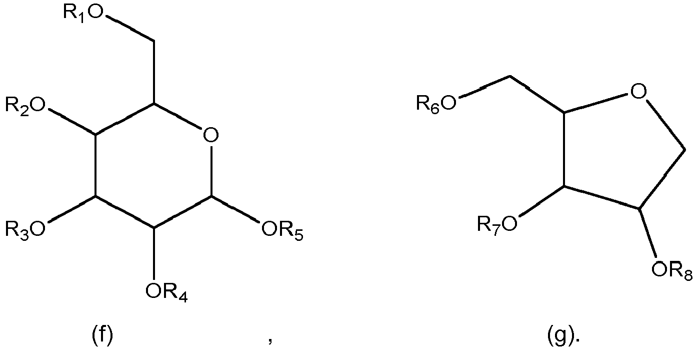

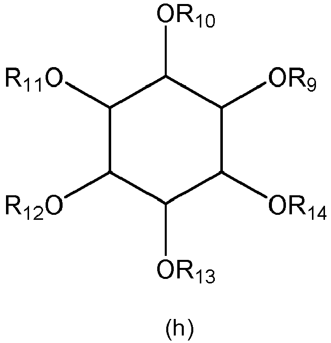

In these general molecular structures; R1, R2, R3, R4, R5, R6, R7, R8 , R9, R10, R11, R12, R13, and R14 can be the same or different atoms or functional groups.

R1 to R14 can each independently be selected from the group consisting of hydrogen, alkyl, alkoxy, an organic group with one or more hydroxyl groups, substituted organic sulfonic acid, a substituted organic sulfonic acid salt, a substituted organic carboxylic acid, a substituted organic carboxylic acid salt, an organic carboxylic ester, an organic amine groups, and combinations thereof; wherein, at least two or more, preferably four or more of them are hydrogen atoms.

When R1, R2, R3 R4, R5, R6, R7 R8 , R9, R10, R11, R12, R13, and R14 are all hydrogen atoms , chemical additives bearing multi hydroxyl functional groups are provided.

The molecular structures of some examples of such chemical additives are listed below:

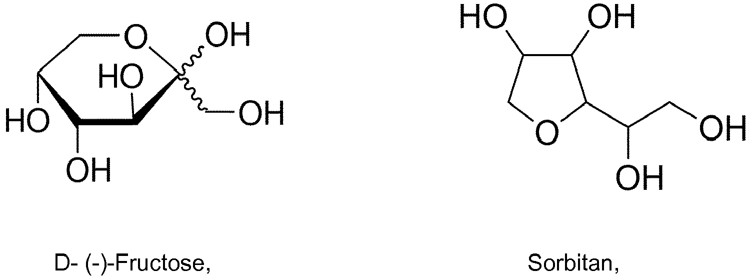

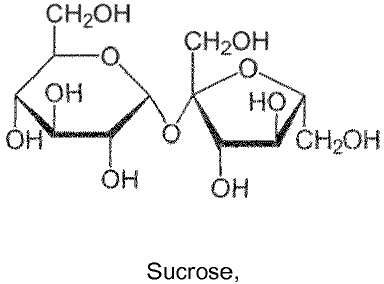

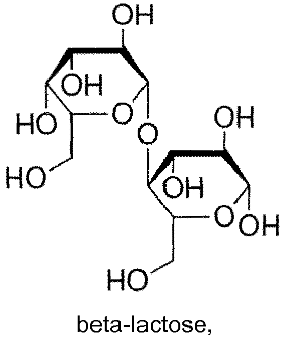

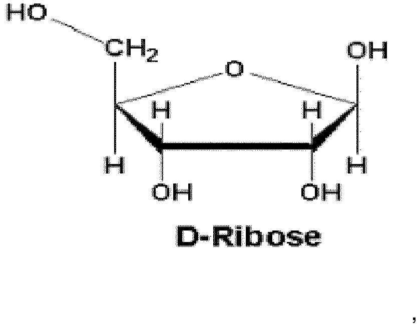

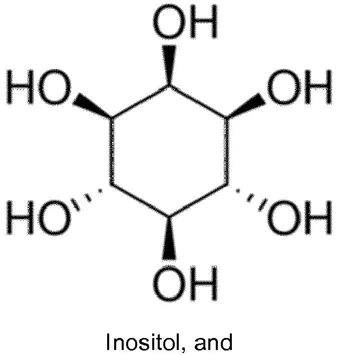

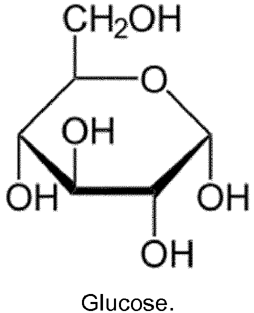

The chemical additives may also contain at least one six-member ring structure motif ether bonded with at least one polyol molecular unit containing multiple hydroxyl functional groups in the molecular unit structures or at least one polyol molecular unit containing multiple hydroxyl functional groups in the molecular unit structures and at least one six-member ring polyol. A polyol is an organic compound containing hydroxyl groups.

The chemical additives used as oxide trenching dishing reducers contain at least two, at least four, or at least six hydroxyl functional groups in their molecular structures.

A general molecular structure for some chemical additives is shown in (a):

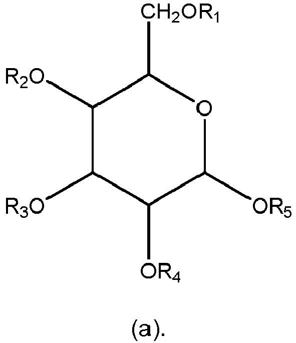

In one embodiment, (hereinafter referred to as a first embodiment), at least one R in the group of R1 to R5 in the general molecular structure is a polyol molecular unit having a structure shown in (b): 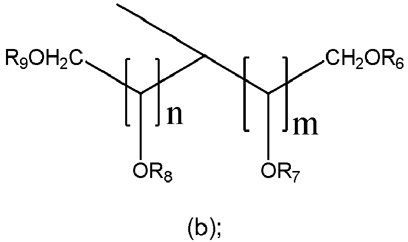 wherein n and m can be the same or different; wherein m and n are each independently selected from 1 to 5, preferably from 1 to 4, more preferably from 1 to 3, and most preferably from 1 to 2; R6 to R9 can be the same or different atoms or functional groups; and each is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof; and
the rest of Rs in the group of R1 to R5 are each independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

In another embodiment, (herein referred to as a second embodiment), at least one R in the group of R1 to R5 in the general molecular structure is a polyol molecular unit having a structure shown in (b); at least one R in the group of R1 to R5 in the general molecular structure is a six-member ring polyol as shown in (c): 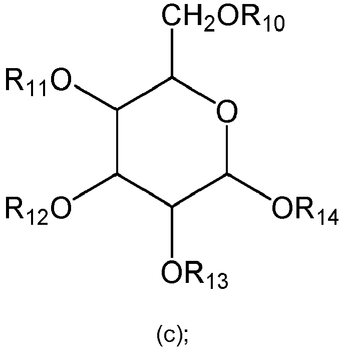
wherein one of the OR in the group of OR11, OR12, OR13 and OR14 is replaced by O in structure (a); and
R10 and each of the other Rs in the group of R10, R11, R12, R13 and R14 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof; and
the rest of the Rs in the group of R1 to R5 are each independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

In the general molecular structure, at least two, preferably four, more preferably six of the Rs in the group of R1 to R9 are hydrogen atoms.

When in the first embodiment only one R, i.e. R5, in the group of R1 to R5 in the general molecular structure is a polyol molecular unit (b) having n = 2 and m =1; and all of the rest of the Rs in the group of R1 to R9 are all hydrogen atoms, the following two chemical additives are obtained:

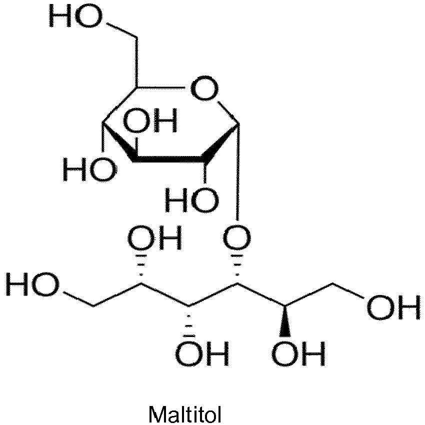

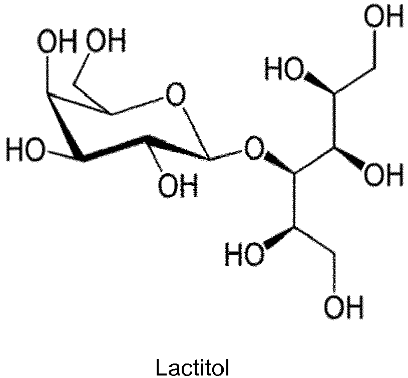

When in the second embodiment one R, specifically R5, is a polyol molecular unit (b) having n = 2 and m =1; and one R, specifically R2, is a six-member ring polyol (with OR14 being replaced by the O in the structure of (a) that is connected to R2); and all of the rest of the Rs in the group of R1 to R13 are all hydrogen atoms, the following chemical additive is obtained:

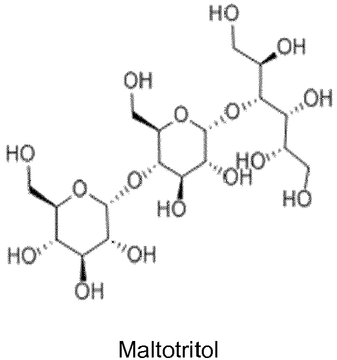

The chemical additive may comprise or consist of maltitol, lactitol, maltotritol, ribitol, D-sorbitol, mannitol, dulcitol, iditol, D- (-)-Fructose, sorbitan, sucrose, Inositol, glucose, D-arabinose, L-arabinose, D-mannose, L-mannose, meso-erythritol, ribose, beta-lactose, or combinations thereof. The preferred chemical additives are maltitol, lactitol, maltotritol, D-sorbitol, mannitol, dulcitol, iditol, D- (-)-Fructose, sucrose, ribose, Inositol, glucose. D-(+)-mannose, beta-lactose, or combinations thereof. The more preferred chemical additives are maltitol, lactitol, maltotritol, D-sorbitol, mannitol, dulcitol, D- (-)-Fructose, beta-lactose, or combinations thereof.

The CMP polishing compositions may be made into two or more parts and mixed at the point of use.

In another aspect, there is provided a method of chemical mechanical polishing (CMP) a substrate having at least one surface comprising silicon dioxide using the chemical mechanical polishing (CMP) composition described above. The polished oxide films can be CVD oxide, PECVD oxide, High density oxide, Spin on oxide films, flowable CVD oxide film, carbon doped oxide film, or nitrogen doped oxide film.

The polished oxide films can be Chemical vapor deposition (CVD), Plasma Enhance CVD (PECVD), High Density Deposition CVD(HDP), or spin on oxide films.

The substrate disclosed above can further comprises a silicon nitride surface. The removal selectivity of SiO₂: SiN is greater than 10, preferably greater than 20, and more preferably greater than 30.

Dishing performance of the CMP compositions can also be characterized by the ratio of oxide trench dishing rate (A/min.) vs the blanket HDP film removal rate(Å/min.).

The smaller of this ratio is, the lower oxide trench dishing is. The CMP compositions having the ratio of ≤ 0.1, 0.08, 0.06, 0.05, 0.03, or 0.02 provide good oxide dishing performance.

In CMP polishing compositions, it is very important to keep abrasive particles stable to assure consistent desired CMP polishing performance.

When using the chemical additives in the CMP polishing compositions, these chemical additives can have some impacts on the stability of abrasive particles in the compositions.

For example, when maltitol, lactitol or their derivatives, are used as oxide trench reducing agents in polishing compositions, these chemical additives can have some impacts on the stability of ceria-coated inorganic oxide abrasives in the CMP polishing compositions.

Typically, the abrasive particle stability is tested by monitoring the mean particle size (MPS) (nm) and particle size distribution parameter D99(nm) changes vs the times or at elevated temperatures.

Particle size distribution may be quantified as a weight percentage of particles that has a size lower than a specified size. For example, parameter D99(nm) represents a particle size (diameter) where 99 wt.% of all the slurry particles would have particle diameter equal to or smaller than the D99(nm). That is, D99(nm) is a particle size that 99 wt.% of the particles fall on and under.

The smaller of MPS (nm) and D99(nm) changes, the more stable of the abrasive particles are and thus the CMP polishing compositions are.

Particle size distribution can be measured by any suitable techniques such as imaging, dynamic light scattering, hydrodynamic fluid fractionation, disc centrifuge etc..

MPS(nm) and D99 (nm) are both measured by dynamic light scattering in this application.

CMP compositions providing abrasive particle stability preferably have changes for MPS (nm) and D99(nm) ≤ 6.0%, 5.0%, 3.0%, 2.0%, 1.0%, 0.5 %, 0.3% or 0.1% for a shelf time of at least 30 days, 40 days, 50 days, 60 days, 70 days or 100 days at a temperature ranging from 20 to 60 °C, 25 to 50 °C.

The following non-limiting examples are presented to further illustrate the present invention.

### CMP Methodology

In the examples presented below, CMP experiments were run using the procedures and experimental conditions given below.

### GLOSSARY

### COMPONENTS

Ceria-coated Silica: used as abrasive having a particle size of approximately 100 nanometers (nm); such ceria-coated silica particles can have a particle size of ranged from approximately 5 nanometers (nm) to 500 nanometers (nm);

Ceria-coated Silica particles (with varied sizes) were supplied by JGC Inc. in Japan.

Chemical additives, such as D-sorbitol, dulcitol, fructose, maltitol, lactitol and other chemical raw materials were supplied by Sigma-Aldrich, St. Louis, MO.

TEOS: tetraethyl orthosilicate

Polishing Pad: Polishing pad, IC1010 and other pads were used during CMP, supplied by DOW, Inc.

### PARAMETERS

### General

Å or A: angstrom(s) - a unit of length
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: slurry flow, ml/min
Wt. %: weight percentage (of a listed component)
TEOS: SiN Selectivity: (removal rate of TEOS)/ (removal rate of SiN)
HDP: high density plasma deposited TEOS
TEOS or HDP Removal Rates: Measured TEOS or HDP removal rate at a given down pressure. The down pressure of the CMP tool was 2.0, 3.0 or 4.0 psi in the examples listed above.
SiN Removal Rates: Measured SiN removal rate at a given down pressure. The down pressure of the CMP tool was 3.0 psi in the examples listed.

### Metrology

Films were measured with a ResMap CDE, model 168, manufactured by Creative Design Engineering, Inc, 20565 Alves Dr., Cupertino, CA, 95014. The ResMap tool is a four-point probe sheet resistance tool. Forty-nine-point diameter scan at 5mm edge exclusion for film was taken.

### CMP Tool

The CMP tool that was used is a 200mm Mirra, or 300mm Reflexion manufactured by Applied Materials, 3050 Boweres Avenue, Santa Clara, California, 95054. An IC1000 pad supplied by DOW, Inc, 451 Bellevue Rd., Newark, DE 19713 was used on platen 1 for blanket and pattern wafer studies.

The IC1010 pad or other pad was broken in by conditioning the pad for 18 mins. At 7 lbs. down force on the conditioner. To qualify the tool settings and the pad break-in two tungsten monitors and two TEOS monitors were polished with Versum® STI2305 slurry, supplied by Versum Materials Inc. at baseline conditions.

### Wafers

Polishing experiments were conducted using PECVD or LECVD or HD TEOS wafers. These blanket wafers were purchased from Silicon Valley Microelectronics, 2985 Kifer Rd., Santa Clara, CA 95051.

### Polishing Experiments

In blanket wafer studies, oxide blanket wafers, and SiN blanket wafers were polished at baseline conditions. The tool baseline conditions were: table speed; 87 rpm, head speed: 93 rpm, membrane pressure; 3.0 psi, inter-tube pressure; 3.1 psi, retaining ring pressure; 5.1 psi, slurry flow; 200 ml/min.

The slurry was used in polishing experiments on patterned wafers (MIT860), supplied by SWK Associates, Inc. 2920 Scott Blvd. Santa Clara, CA 95054). These wafers were measured on the Veeco VX300 profiler/AFM instrument. The 3 different sized pitch structures were used for oxide dishing measurement. The wafer was measured at center, middle, and edge die positions.

TEOS: SiN Selectivity: (removal rate of TEOS)/ (removal rate of SiN) obtained from the CMP polishing compositions were tunable.

### Working Examples

In the following working examples, a polishing composition comprising 0.2 wt.% cerium-coated silica, a biocide ranging from 0.0001 wt.% to 0.05 wt.%, and deionized water was prepared as reference (ref.).

The polishing compositions were prepared with the reference (0.2 wt.% cerium-coated silica, a biocide ranging from 0.0001 wt.% to 0.05 wt.%, and deionized water) plus a chemical additive in 0.01 wt.% to 2.0 wt.%.

All examples, except pH condition examples the composition had a pH at 5.35.

pH adjusting agent used for acidic pH condition and alkaline pH condition were nitric acid and ammonium hydroxide respectively.

### Example 1

The working slurries has 0.15 wt.% chemical additives added to the reference slurry.

The effects of various selected chemical additives on the film removal rates and selectivity were observed.

The removal rates (RR at Å/min) for different films were tested. The test results were listed in Table 1.

As the results showed in Table 1, the slurries based on ceria-coated silica offered higher removal rate for TEOS.

**Table 1. Effects of Chemical Additives on Film RR (A/min.) & TEOS: SiN Selectivity**

| Samples | TEOS-RR (ang/min) | HDP-RR (ang/min) | SiN-RR (ang/min) | TEOS: SiN Selectivity |
|---|---|---|---|---|
| 0.2 wt.% Ceria-coated Silica (Ref.) | 3279 | 2718 | 349 | 9 |
| Ref.+0.15 wt.% D-Sorbitol | 2394 | 2299 | 75 | 32 |
| Ref.+0.15 wt.% D-Mannitol | 2741 | 2372 | 124 | 22 |
| Ref.+0.15 wt.% D- (+)-Mannose | 2839 | 2104 | 148 | 19 |
| Ref.+ 0.15 wt.% Xylitol | 2694 | 2256 | 109 | 25 |
| Ref.+ 0.15 wt.% meso-Erythritol | 2808 | 2064 | 366 | 8 |

As the results in Table 1 show, the chemical additives D-sorbitol, D-mannitol, D-mannose, and xylitol, suppressed SiN removal rates comparing with the Ref., while still providing high TEOS and HDP film removal rates and provided high Oxide: SiN selectivity.

### Example 2

In Example 2, 0.2 wt.% ceria-coated silica abrasive based formulation without chemical additives was used as reference.

The chemical additives were used at 0.15 wt.% (0.15X) concentrations respectively with 0.2 wt.% ceria-coated silica as abrasives in the working slurries.

The test results are listed in Table 2. HDP RR (A/min.) from Table 1 iss also listed in Table 2.

**Table 2. Effects of Chemical Additives on Oxide Trench Dishing & HDP RR (A/min.)**

| **Compositions** | **OP Time (sec.)** | **100um pitch dishing** | **200um pitch dishing** | **Blanket HDP RR (A/min.)** |
|---|---|---|---|---|
| 0.2% Ceria-coated Silica pH 5.35 | 0 | 165 | 291 | 2718 |
| | 60 | 857 | 1096 | |
| | 120 | 1207 | 1531 | |
| 0.2% Ceria-coated Silica +0.15X D-Sorbitol | 0 | 137 | 276 | 2299 |
| | 60 | 247 | 411 | |
| | 120 | 380 | 544 | |
| 0.2% Ceria-coated Silica +0.15X D-mannitol | 0 | 162 | 285 | 2372 |
| | 60 | 368 | 580 | |
| | 120 | 563 | 816 | |
| 0.2% Ceria-coated Silica +0.15X D-(+)-Mannose | 0 | 181 | 272 | 2401 |
| | 60 | 660 | 973 | |
| | 120 | 1121 | 1553 | |
| 0.2% Ceria-coated Silica+0.15X Xylitol | 0 | 144 | 258 | 2256 |
| | 60 | 485 | 800 | |
| | 120 | 760 | 1166 | |
| 0.2% Ceria-coated Silica + 0.15X meso-Erythritol | 0 | 131 | 265 | 2064 |
| | 60 | 732 | 896 | |
| | 120 | 1125 | 1392 | |

Table 3 lists the ratio of oxide trench dishing rate (A/min.) vs the blanket HDP film removal rate(Å/min.),

**Table 3. The Ratio of Trench Dishing Rate (Å)/Blanket HDP RR (Å/min.)**

| Compositions | P100 Dishing Rate (Å/min.) /Blanket HDP RR (Å/min.) | P200 Dishing Rate (Å/min.) /Blanket HDP RR (Å/min.) |
|---|---|---|
| 0.2% Ceria-coated Silica pH 5.35 | 0.13 | 0.16 |
| 0.2% Ceria-coated Silica + 0.15X D-Sorbitol | 0.06 | 0.06 |
| 0.2% Ceria-coated Silica + 0.15X D-mannitol | 0.08 | 0.12 |
| 0.2% Ceria-coated Silica + 0.15X D-(+)-Mannose | 0.2 | 0.24 |
| 0.2% Ceria-coated Silica + 0.15X Xylitol | 0.12 | 0.16 |
| 0.2% Ceria-coated Silica + 0.15X meso-Erythritol | 0.19 | 0.24 |

As the results in Tables 2 and 3 show, the addition of various chemical additives used as oxide trench dishing reducers in polishing compositions had different effects.

The polishing compositions using D-sorbitol and D-mannitol provided significant oxide trench dishing reductions on both100µm pitch and 200µm pitch respectively, comparing to the reference.

The polishing composition using xylitol showed no impact on oxide trench dishing in polishing comparing to the reference. The polishing compositions using D-(+)-mannose or meso-erythritol had the oxide trench dishing worse than the reference.

The effects of chemical additives on the slopes of oxide trenching dishing vs over polishing removal amounts are listed in Table 4.

**Table 4. Effects of Chemical Additives on Slopes of Dishing vs OP Removal Amount**

| **Compositions** | **P100 dishing/OP Amt Slope** | **P200 dishing/OP Amt Slope** | **P1000 dishing/OP Amt Slope** |
|---|---|---|---|
| 0.2X Ceria-coated Silica | 0.19 | 0.23 | 0.25 |
| 0.2X Ceria-coated Silica + 0.15x D-Sorbitol | 0.05 | 0.06 | 0.08 |
| 0.2X Ceria-coated Silica + 0.15x D-Mannitol | 0.08 | 0.11 | 0.40 |
| 0.2X Ceria Coated + 0.15x D-(+)-Mannose | 0.20 | 0.27 | 0.38 |
| 0.2X Ceria-coated Silica + 0.15x Xylitol | 0.14 | 0.20 | 0.41 |

As the results in Table 4 show, the polishing composition using D-sorbitol or D-mannitol afforded much lower slope values of oxide trench dishing vs over polishing amounts on 100µm and 200µm features when compared to the reference.

The other additives offered no dishing improvements compared to the reference.

### Example 3

The effects of various selected chemical additives on the film removal rates (RR at Å/min) and selectivity were observed. These chemical additives were used at 0.1 wt.% concentrations respectively with 0.2 wt.% ceria-coated silica as abrasives.

The test results are listed in Table 5.

**Table 5. Effects of Chemical Additives on Film RR (A/min.) & TEOS: SiN Selectivity**

| Samples | TEOS-RR (ang/min) | HDP-RR (ang/min) | SiN-RR (ang/min) | TEOS: SiN Selectivity |
|---|---|---|---|---|
| 0.2% Ceria-Coated Silica | 3279 | 2718 | 349 | 9.4 |
| + 0.1 x D-Sorbitol | 2968 | 2814 | 92 | 32.3 |
| + 0.1x D- (-)-Fructose | 1662 | 1781 | 34 | 48.9 |
| + 0.1x Maltitol | 2834 | 2679 | 38 | 74.6 |
| + 0.1x Dulcitol | 3127 | 2995 | 45 | 69.5 |

As the results in Table 5 show, the chemical additives D-sorbitol, D- (-)-Fructose, Maltitol and Dulcitol suppressed SiN removal rates as compared to the reference, and still provided high TEOS and HDP film removal rates.

The CMP composition having D- (-)-fructose suppressed removal of TEOS in addition of SiN, but still provided high TEOS: SiN selectivity.

The effects of various selected chemical additives on the oxide trenching dishing vs over polishing times were observed.

The test results are listed in Table 6. HDP RR (A/min.) from Table 5 was also listed in Table 6.

**Table 6. Effects of Chemical Additives on Oxide Trench Dishing & HDP RR (A/min.)**

| **Samples** | **OP Time (Sec.)** | **100um pitch dishing** | **200um pitch dishing** | **1000um pitch dishing** | **Blanket HDP RR (A/min.)** |
|---|---|---|---|---|---|
| 0.2% Ceria-coated Silica | 0 | 165 | 291 | 1013 | 2718 |
| | 60 | 857 | 1096 | 1821 | |
| | 120 | 1207 | 1531 | 2392 | |
| 0.2% Ceria-coated Silica + 0.1x D-Sorbitol | 0 | 98 | 184 | 432 | 2814 |
| | 60 | 261 | 383 | 1494 | |
| | 120 | 418 | 583 | 1936 | |
| 0.2% Ceria-coated Silica + 0.1x D- (-)-Fructose | 0 | 123 | 229 | 694 | 1781 |
| | 60 | 315 | 372 | 962 | |
| | 120 | 458 | 527 | 1175 | |
| 0.2% Ceria-coated Silica + 0.1x Maltitol | 108 | 218 | 620 | 620 | 2679 |
| | 228 | 355 | 873 | 873 | |
| | 333 | 482 | 1068 | 1068 | |
| 0.2% Ceria-coated Silica + 0.1x Dulcitol | 0 | 152 | 252 | 770 | 2995 |
| | 60 | 238 | 370 | 10 | |
| | 120 | 366 | 495 | 1081 | |

As the oxide trench dishing vs over polishing time results in Table 6 show, the CMP compositions with chemical additives provided lower oxide trench dishing on 100um pitch, and 200um pitch, respectively. The compositions provided significant oxide trench dishing reductions as compared to the reference composition.

Table 7 lists the ratio of oxide trench dishing rate (A/min.) vs the blanket HDP film removal rate(Å/min.),

As the results in Table 7 show, the addition of the chemical additives to the polishing compositions significantly reduced the ratio of trench dishing rate vs the blanket HDP film removal rates compared to the ratio obtained from the reference sample at pH 5.35.

**Table 7. The Ratio of Trench Dishing Rate (Å)/Blanket HDP RR (A/min.)**

| Compositions | P100 Dishing Rate (Å/min.)/Blanket HDP RR (Å/min.) | P200 Dishing Rate (Å/min.)/Blanket HDP RR (Å/min.) |
|---|---|---|
| 0.2X Ceria-coated Silica | 0.13 | 0.16 |
| + 0.1xD-Sorbitol | 0.06 | 0.07 |
| + 0.1xD-(-)-Fructose | 0.08 | 0.09 |
| + 0.1x Maltitol | 0.05 | 0.07 |
| + 0.1xDulcitol | 0.04 | 0.04 |

The slopes of the various sized pitch dishing vs oxide over polishing amounts are listed in Table 8.

**Table 8. Effects of Chemical Additives on Slopes of Dishing vs OP Removal Amount**

| **Compositions** | **P100 dishing/OP Amt Slope** | **P200 dishing/OP Amt Slope** | **P1000 dishing/OP Amt Slope** |
|---|---|---|---|
| 0.2X Ceria-coated Silica | 0.19 | 0.23 | 0.25 |
| + 0.1x D-Sorbitol | 0.06 | 0.07 | 0.27 |
| + 0.1x D- (-)-Fructose | 0.09 | 0.08 | 0.14 |
| + 0.1x Maltitol | 0.04 | 0.05 | 0.08 |
| + 0.1x Dulcitol | 0.04 | 0.04 | 0.05 |

As the results of slopes of the various sized pitch dishing vs oxide over polishing amounts in Table 8 show, the chemical additives and ceria-coated silica abrasives based CMP polishing compositions provided much lower slope values comparing to those slope values obtained from the reference.

### Example 4

In Example 4, the removal rates, and TEOS: SiN selectivity were tested tests were performed with CMP polishing compositions with chemical additives having different concentrations at pH 5.35.

The test results are listed in Table 9.

**Table 9. Effects of Additive Conc. on Film RR (A/min.) & Selectivity of Oxide: SiN**

| Samples | TEOS-RR (ang/min) | HDP-RR (ang/min) | SiN-RR (ang/min) | TEOS: SiN Sel. |
|---|---|---|---|---|
| 0.2% Ceria-coated Silica + 0.05x D-Sorbitol | 3595 | 3128 | 110 | 33 |
| 0.2% Ceria-coated Silica + 0.1 x D-Sorbitol | 3821 | 3425 | 112 | 34 |
| 0.2% Ceria-coated Silica + 0.15x D-Sorbitol | 3651 | 3517 | 83 | 44 |

As the results in Table 9 show, when the concentration of D-sorbitol used in the compositions increased, similar TEOS removal rates were obtained, the HPD film removal rates were increased and TEOS: SiN selectivity were also increased slightly or significantly.

The effects on the oxide trenching dishing vs over polishing times from the selected chemical additive D-sorbitol concentrations on the various sized pitch features were tested.

The test results are listed in Table 10.

**Table 10. Effects of Chemical Additive D-Sorbitol Conc. On Oxide Trench Dishing vs OP Times(sec.)**

| **Compositions** | **Polish Time (Sec.)** | **100um pitch dishing** | **200um pitch dishing** | **Blanket HDP RR** |
|---|---|---|---|---|
| 0.2% Ceria-coated Silica + 0.05x D-Sorbitol | 0 | 198 | 332 | 3128 |
| | 60 | 453 | 690 | |
| | 120 | 573 | 842 | |
| 0.2% Ceria-coated Silica + 0.1x D-Sorbitol | 0 | 182 | 288 | 3425 |
| | 60 | 355 | 551 | |
| | 120 | 499 | 736 | |
| 0.2% Ceria-coated Silica + 0.15x D-Sorbitol | 0 | 132 | 246 | 3517 |
| | 60 | 269 | 423 | |
| | 120 | 423 | 595 | |

As the results in Table 10 show, all 3 tested CMP polishing compositions containing D-sorbitol with different concentrations gave low oxide trench dishing on both 100µm pitch and 200µm pitch.

Also, as the chemical additive D-sorbitol concentrations increased, the oxide trench dishing is further reduced.

Table 11 lists the ratio of Trench Dishing Rate (Å)/Blanket HDP RR (Å/min.) from the compositions with different concentrations of D-Sorbitol.

**Table 11 Ratio of Trench Dishing Rate (Å)/Blanket HDP RR (A/min.) vs Conc. of D-Sorbitol**

| Compositions | P100 Dishing Rate (Å/min.) /Blanket HDP RR (Å/min.) | P200 Dishing Rate (Å/min.) /Blanket HDP RR (Å/min.) |
|---|---|---|
| 0.2% Ceria-coated Silica + 0.05X D-Sorbitol | 0.04 | 0.05 |
| 0.2% Ceria-coated Silica + 0.1X D-Sorbitol | 0.04 | 0.05 |
| 0.2% Ceria-coated Silica + 0.15X D-Sorbitol | 0.04 | 0.05 |

As the results in Table 11 show, D-sorbitol used in the compositions at pH 5.35, all significantly reduced the ratio of trench dishing rate vs the blanket HDP film removal rates across the different tested concentrations.

Therefore, D-sorbitol can be used as an effective oxide trench dishing reducer in a wide concentration range.

The slopes of the various sized pitch dishing vs oxide over polishing amounts were tested and the results listed in Table 12.

**Table 12. Effects of Additive Conc. on Slopes of Dishing vs OP Removal Amount**

| Compositions | P100 dishing/OP Amt Slope | P200 dishing/OP Amt Slope |
|---|---|---|
| STI2305 (Reference) | 0.01 | 0.01 |
| 0.2% Ceria-coated Silica + 0.05x D-Sorbitol | 0.06 | 0.08 |
| 0.2% Ceria-coated Silica + 0.1x D-Sorbitol | 0.05 | 0.07 |
| 0.2% Ceria-coated Silica + 0.15x D-Sorbitol | 0.04 | 0.05 |

As the results of slopes of the various sized pitch dishing vs oxide over polishing amounts in Table 12 show, different concentrations of D-sorbitol in CMP polishing compositions all afforded similar slope values as compared to the reference sample.

Also, as the D-sorbitol concentration increased, the slopes of the various sized pitch dishing vs oxide over polishing gradually decreased while at over polishing time at zero seconds.

### Example 5

In Example 5, the tests were performed with CMP polishing compositions having different pH values.

The composition composed of 0.2 wt.% ceria-coated silica as abrasives. and 0.1 wt.% D-sorbitol as chemical additive was tested at three different pH conditions.

The removal rates (RR at Å/min) for different films were tested. The test results were listed in Table 13.

**Table 13. Effects of pH on Film RR (A/min.) & Selectivity of Oxide: SiN**

| 0.2% Ceria-coated Silica + 0.1% D-Sorbitol | TEOS-RR (ang/min) | HDP-RR (ang/min) | SiN-RR (ang/min) | TEOS: SiN Sel. |
|---|---|---|---|---|
| pH 5.35 | 3821 | 3425 | 112 | 34 |
| pH 6 | 3759 | 3415 | 131 | 29 |
| pH 8 | 2932 | 3084 | 94 | 31 |

As the results in Table 10 show, the compositions showed a consistent performance by offering high TEOS and HDP film removal rates, low SiN removal rates, and high TEOS: SiN selectivity in acidic, neutral or alkaline pH conditions..

The effects of pH conditions on using the CMP polish compositions on oxide trench dishing vs over polishing times was tested.

The results are listed in Table 14.

As the results in Table 14 show, similar oxide trenching dishing vs over polishing times and HDP film removal rates were obtained for the same concentration of ceria-coated silica as abrasives and D-sorbitol as oxide trenching dishing reducing agent at 3 different pH conditions.

**Table 14. Effects of pH Conditions on Oxide Trench Dishing vs Over Polishing Times(sec.) & HDP Film RR (A/min.)**

| **Compositions & pH** | **Polish Time (Sec.)** | **100um pitch dishing** | **200um pitch dishing** | **Blanket HDP RR** |
|---|---|---|---|---|
| 0.2% Ceria-coated Silica + 0.1 x D-Sorbitol (pH 5.35) | 0 | 182 | 288 | 3425 |
| | 60 | 355 | 551 | |
| | 120 | 499 | 736 | |
| 0.2% Ceria-coated Silica + 0.1 x D-Sorbitol (pH 6) | 0 | 169 | 325 | 3415 |
| | 60 | 354 | 566 | |
| | 120 | 506 | 800 | |
| 0.2% Ceria-coated Silica + 0.1 x D-Sorbitol (pH 8) | 0 | 193 | 360 | 3084 |
| | 60 | 391 | 615 | |
| | 120 | 537 | 814 | |

Table 15 shows the results of the ratio of Trench Dishing Rate (Å)/Blanket HDP RR (Å/min.),

**Table 15 Ratio of Trench Dishing Rate (Å)/Blanket HDP RR (Å/min.) at Different pH**

| Compositions | P100 Dishing Rate (Å/min.) /Blanket HDP RR (A/min.) | P200 Dishing Rate (Å/min.) /Blanket HDP RR (A/min.) |
|---|---|---|
| 0.2% Ceria-coated Silica + 0.1X D-Sorbitol (pH 5.35) | 0.04 | 0.05 |
| 0.2% Ceria-coated Silica + 0.1X D-Sorbitol (pH 6) | 0.04 | 0.07 |
| 0.2% Ceria-coated Silica + 0.1X D-Sorbitol (pH 7) | 0.05 | 0.06 |

As the results in Table 15 show, the addition of the chemical additive, D-sorbitol, when used as oxide trench dishing reducer in polishing compositions at different pH conditions, showed significant reduction of the ratio which indicated that D-sorbitol can be used as a very effective oxide trench dishing reducing agent at wide pH window.

### Example 6

In Example 6, the effects of various selected chemical additives from afore listed several types of chemical additives on the film removal rates and selectivity were observed.

The same molar concentrations of all tested chemical additives, 8.132mM, was used respectively.

All examples, except examples for the pH condition test had a pH at 5.35.

For the examples used in the pH condition test, pH adjusting agent was used for acidic pH condition and alkaline pH condition were nitric acid and ammonium hydroxide respectively.

The removal rates (RR at Å/min) and removal selectivity for different films were tested. The test results are listed in Table 16.

As the results in Table 16show, these chemical additives, when used at 8.132mM concentrations in the polishing compositions afforded similar TEOS film removal rates, HDP film removal rates, slightly or significantly suppressed SiN removal rates as compared with the reference.

**Table 16. Effects of 8.132mM Concentration of Chemical Additives on Film RR (A/min.) & TEOS: SiN Selectivity**

| Compositions | TEOS RR (A/min.) | HDP RR (A/min.) | PECVD SiN RR (A/min.) | TEOS: SiN Selectivity |
|---|---|---|---|---|
| 0.2% Ceria-coated Silica | 2754 | 1886 | 432 | 6.4 |
| 0.2% Ceria-coated Silica + 8.132mM Maltitol | 2609 | 2493 | 45 | 58.4 |
| 0.2% Ceria-coated Silica + 8.132mM Ribose | 2862 | 2512 | 114 | 25.1 |
| 0.2% Ceria-coated Silica + 8.132mM Arabinose | 2963 | 1985 | 393 | 7.5 |
| 0.2% Ceria-coated Silica + 8.132mM Beta-lactose | 2913 | 2186 | 115 | 25.3 |
| 0.2% Ceria-coated Silica + 8.132mM Myo-Inositol | 2899 | 2028 | 201 | 14.4 |

The Oxide: SiN selectivity was fluctuating from slightly increased (arabinose, myo-inositol) to significantly increased (maltitol, ribose and beta-lactose). Among these tested chemical additives, maltitol is the most efficient SiN removal rate suppressing chemical additive, and ribose and beta-lactose are also quite efficient SiN removal rate suppressing additives.

### Example 7

The following chemical additives, maltitol, D-sorbitol, lactitol, ribose, and beta-lactose were used in the polishing compositions with 0.2 wt.% ceria-coated silica abrasives at pH 5.35 to conduct polishing tests on polishing oxide patterned wafers. The chemical additives were used at 0.15 wt.% in the compositions.

The effects of various chemical additives on the film removal rates and selectivity were observed.

The test results are listed in Table 17.

As the results in Table 17 show, all compositions afforded similar high TEOS film removal rates, increased HDP film high removal rates, significantly suppressed SiN removal rates, significantly increased Oxide: SiN selectivity as compared with the reference sample.

**Table 17. Effects of Chemical Additives on Film RR (A/min.) & TEOS: SiN Selectivity**

| Composition | TEOS RR (A/min) | HDP RR (A/min) | SiN RR (A/min) | TEOS: SiN Selectivity |
|---|---|---|---|---|
| 0.2% Ceria-coated Silica pH 5.35 | 4310 | 3047 | 557 | 8 |
| 0.2% Ceria-coated Silica + 0.15% D-sorbitol | 3605 | 3992 | 65 | 36 |
| 0.2% CPOP + 0.15% Maltitol | 4505 | 4203 | 61 | 39 |
| 0.2% CPOP + 0.15% Lactitol | 4563 | 4183 | 85 | 41 |
| 0.2% CPOP + 0.15% Ribose | 4517 | 4325 | 103 | 39 |
| 0.2% CPOP + 0.15% Beta-Lactose | 4716 | 4049 | 80 | 46 |

The effects of various chemical additives on the oxide trenching dishing vs over polishing times were observed. These chemical additives were used at 0.15 wt.% (0.15X) concentrations respectively with 0.2 wt.% ceria-coated silica as abrasive, and with all formulations at pH 5.35.

The test results were listed in Table 18.

**Table 18. Effects of Chemical Additives on Oxide Trench Dishing & HDP RR (A/min.)**

| **Compositions** | **OP Time (sec.)** | **100um pitch dishing** | **200um pitch dishing** |
|---|---|---|---|
| 0.2% Ceria-coated Silica pH 5.35 | 0 | 165 | 291 |
| | 60 | 857 | 1096 |
| | 120 | 1207 | 1531 |
| 0.2% Ceria-coated Silica + 0.15% Sorbitol | 0 | 94 | 222 |
| | 60 | 216 | 351 |
| | 120 | 314 | 475 |
| 0.2% Ceria-coated Silica + 0.15% Maltitol | 0 | 135 | 261 |
| | 60 | 293 | 463 |
| | 120 | 413 | 641 |
| 0.2% Ceria-coated Silica + 0.15% Lactitol | 0 | 120 | 193 |
| | 60 | 313 | 436 |
| | 120 | 468 | 646 |
| 0.2% Ceria-coated Silica + 0.15% Ribose | 0 | 88 | 176 |
| | 60 | 290 | 409 |
| | 120 | 441 | 606 |
| 0.2% Ceria-coated Silica + 0.15% Beta-Lactose | 0 | 141 | 259 |
| | 60 | 387 | 587 |
| | 120 | 579 | 870 |

As the oxide trench dishing vs over polishing time results in Table 18 show, all of these chemical additives, when used with ceria-coated silica abrasives in the CMP polishing compositions, afforded largely reduced oxide trench dishing vs over polishing times at 60 seconds or 120 seconds respectively on 100µm pitch and 200µm pitch features, and provided significant oxide trench dishing reductions compared to the reference.

Table 19 shows the results of the ratio of Trench Dishing Rate (Å)/Blanket HDP RR (Å/min.),

**Table 19 Ratio of Trench Dishing Rate (Å)/Blanket HDP RR (Å/min.)**

| **Compositions** | P100 Dishing Rate (Å/min.) /Blanket HDP RR (Å/min.) | P200 Dishing Rate (Å/min.) /Blanket HDP RR (Å/min.) |
|---|---|---|
| 0.2% Ceria-coated Silica pH 5.35 | 0.13 | 0.16 |
| 0.2% Ceria-coated Silica + 0.15% Sorbitol | 0.02 | 0.03 |
| 0.2% Ceria-coated Silica + 0.15% Maltitol | 0.05 | 0.04 |
| 0.2% Ceria-coated Silica + 0.15% Lactitol | 0.04 | 0.05 |
| 0.2% Ceria-coated Silica + 0.15% Ribose | 0.03 | 0.05 |
| 0.2% Ceria-coated Silica + 0.15% Beta-Lactose | 0.05 | 0.07 |

As the results in Table 19 show, all tested polishing compositions using chemical additives showed significantly reduction of the ratio of trench dishing rate vs the blanket HDP film removal rates which indicated that all these chemical additives can be used as very effective oxide trench dishing reducing agents in the invented CMP polishing compositions.

### Working Example 8

The polishing compositions were prepared with the reference (0.2 wt.% ceria-coated silica, a biocide ranging from 0.0001 wt.% to 0.05 wt.%, and deionized water) and maltitol or lactitol were used at 0.28 wt.%.

All example compositions had a pH at 5.35.

The removal rates (RR at Å/min) for different films were tested. The effects of two selected chemical additives, maltitol and lactitol on the film removal rates and selectivity were observed.

The test results are listed in Table 20.

**Table 20. Effects of Maltitol or Lactitol on Film RR (Å /min.) & TEOS: SiN Selectivity**

| Compositions | TEOS Film RR (Å/min.) | HDP Film RR (Å/min.) | SiN Film RR (Å/min.) | TEOS: SiN Selectivity |
|---|---|---|---|---|
| 0.2% Ceria-coated Silica pH 5.35 | 3279 | 2718 | 349 | 9.4 |
| 0.2% Ceria-coated Silica + 0.28% Maltitol pH 5.35 | 2623 | 2639 | 46 | 57.0 |
| 0.2% Ceria-coated Silica + 0.28% Lactitol pH 5.35 | 2630 | 2547 | 55 | 47.8 |

As the results in Table 20 show, the addition of the chemical additives, maltitol or lactitol, in the polishing compositions, significantly suppressed SiN removal rates while still providing high TEOS and HDP film removal rates, thus, significantly increased Oxide: SiN film polishing selectivity.

### Example 9

The example compositions in Example 8 were used in this Example.

Oxide trenching dishing without/or with different over polishing times were tested. The effects of maltitol or lactitol on the oxide trenching dishing vs over polishing times were observed.

The test results are listed in Table 21.

**Table 21. Effects of Maltitol or Lactitol on Oxide Trench Dishing vs OP Times (Sec.)**

| **Compositions** | **OP Times (Sec.)** | **100um pitch dishing** | **200um pitch dishing** |
|---|---|---|---|
| 0.2% Ceria-coated Silica pH 5.35 Ref. | 0 | 165 | 291 |
| | 60 | 857 | 1096 |
| | 120 | 1207 | 1531 |
| | | | |
| 0.2% Ceria-coated Silica + 0.28% Maltitol pH 5.35 | 0 | 408 | 616 |
| | 60 | 480 | 713 |
| | 120 | 542 | 803 |
| | | | |
| 0.2% Ceria-coated Silica + 0.28% Lactitol pH 5.35 | 0 | 349 | 563 |
| | 60 | 438 | 702 |
| | 120 | 510 | 779 |

As the results in Table 21 show, the polishing compositions with the addition of the chemical additives, maltitol or lactitol, afforded low oxide trench dishing on 100µm pitch, and 200µm pitch respectively when 60second or 120second over polishing times were applied.

The compositions provided significant oxide trench dishing reductions compared to the reference composition which did not have the chemical additives, maltitol or lactitol.

Table 22 shows the results of the ratio of Trench Dishing Rate (Å)/Blanket HDP RR (Å/min.),

**Table 22. The Ratio of Trench Dishing Rate (A)/Blanket HDP RR (A/min.)**

| Compositions | **P100 Dishing Rate (Å/min.) /Blanket HDP RR (A/min.)** | **P200 Dishing Rate (Å/min.) /Blanket HDP RR (A/min.)** |
|---|---|---|
| 0.2% Ceria-coated Silica pH 5.35 | 0.13 | 0.16 |
| 0.2% Ceria-coated Silica + 0.28% Maltitol pH 5.35 | 0.02 | 0.03 |
| 0.2% Ceria-coated Silica + 0.28% Lactitol pH 5.35 | 0.03 | 0.03 |

As the results in Table 22 show, the addition of either maltitol or lactitol as oxide trench dishing reducer in polishing compositions significantly reduced the ratio of trench dishing rate vs the blanket HDP film removal rates, the lower this ratio is, the lower of oxide trench dishing.

The slopes of oxide trench dishing vs the OP removal amount is shown in Table 23.

**Table 23. Effects of Maltitol or Lactitol on Slopes of Dishing vs OP Removal Amount**

| **Compositions** | **P100 dishing/OP Amt Slope** | **P200 dishing/OP Amt Slope** | **P1000 dishing/OP Amt Slope** |
|---|---|---|---|
| 0.2% Ceria-coated Silica pH 5.35 Ref. | 0.19 | 0.23 | 0.25 |
| 0.2% Ceria-coated Silica + 0.28% Maltitol pH 5.35 | 0.04 | 0.05 | 0.08 |
| 0.2% Ceria-coated Silica + 0.28% Lactitol pH 5.35 | 0.04 | 0.06 | 0.09 |

The results listed in Table 23 indicate that the compositions with chemical additives, maltitol or lactitol provided lower slopes which indicated a good over polishing window for maintaining low oxide trench dishing even when more oxide film is removed in over polishing steps.

As shown in Table 23, these chemical additives, maltitol or lactitol, and ceria-coated silica based CMP polishing compositions again showed much lower slope values comparing to those slope values obtained for the ceria-coated silica abrasive based reference sample.

### Example 10

In Example 10, the trench oxide loss rates were compared for the polishing compositions using maltitol or lactitol and reference as listed in Table 24.

**Table 24. Effects of Maltitol or Lactitol on Trench Loss Rates (A/min.)**

| Compositions | P100Trench Loss Rate (Å/sec.) | P200Trench Loss Rate (Å/sec.) |
|---|---|---|
| 0.2% Ceria-coated Silica pH 5.35 Ref. | 18.5 | 19.3 |
| 0.2% Ceria-coated Silica + 0.28% Maltitol pH 5.35 | 2.0 | 2.5 |
| 0.2% Ceria-coated Silica + 0.28% Lactitol pH 5.35 | 2.3 | 2.6 |

As the results in Table 24 show, by adding maltitol or lactitol as oxide trench dishing reducing agent into the polishing compositions, the trench loss rates were significantly reduced vs the reference sample without any chemical additives.

### Example 11

The compositions were prepared as shown in Table 19.

The compositions used of 0.2 wt.% ceria-coated silica as abrasives, 0.28 wt.% lactitol as chemical additive, biocide, DI water, and a pH adjusting agent to provide different pH conditions.

The removal rates (RR at Å/min) for different films were tested. The effects of pH conditions on the film removal rates and selectivity were observed.

The test results are listed in Table 25.

**Table 25. Effects of pH on Film RR (Å/min) & Selectivity of Oxide: SiN**

| Compositions | TEOS Film RR (Å/min.) | HDP Film RR (Å/min.) | SiN Film RR (Å/min.) | TEOS:SiN Selectivity |
|---|---|---|---|---|
| 0.2% Ceria-coated Silica pH 5.35 | 3279 | 2718 | 349 | 9.4 |
| 0.2% Ceria-coated Silica + 0.28% Lactitol pH 5.35 | 2623 | 2639 | 46 | 57.0 |
| 0.2% Ceria-coated Silica + 0.28% Lactitol pH 7.0 | 2524 | 2517 | 56 | 45.1 |
| 0.2% Ceria-coated Silica + 0.28% Lactitol pH 8.0 | 2401 | 2417 | 52 | 46.2 |

As the results in Table 25 show, the addition of lactitol as oxide trench dishing reducing agent into the polishing compositions at three different pH conditions, (acidic, neutral or alkaline) gave similar TEOS and HDP film removal rates, very effectively suppressed SiN film removal rates, and yielded much higher TEOS: SiN selectivity compared to the reference sample without using lactitol as chemical additive.

Oxide trenching dishing for without/or with lactitol as chemical additive over polishing times were tested.

The effects of lactitol containing polishing composition at different pH conditions on the oxide trenching dishing vs over polishing times were observed.

The test results are listed in Table 26.

As the results in Table 26 show, the polishing compositions with the addition of lactitol, at different pH conditions provided low oxide trench dishing on 100µm pitch, and 200µm pitch respectively when 60 second or 120 second over polishing times were applied.

The compositions with lactitol as oxide trench dishing reducing agent provided significant oxide trench dishing reductions as compared to the reference polishing composition which did not have the chemical additive, lactitol.

**Table 26. Effects of Lactitol at Different pH Conditions on Oxide Trench Dishing vs OP Times (Sec.)**

| Compositions | OP Times (Sec.) | 100um pitch dishing | 200um pitch dishing |
|---|---|---|---|
| 0.2% Ceria-coated Silica pH 5.35 Ref. | 0 | 165 | 291 |
| | 60 | 857 | 1096 |
| | 120 | 1207 | 1531 |
| | | | |
| 0.2% Ceria-coated Silica + 0.28% Lactitol pH 5.35 | 0 | 349 | 563 |
| | 60 | 438 | 702 |
| | 120 | 510 | 779 |
| | | | |
| 0.2% Ceria-coated Silica + 0.28% Lactitol pH 7.0 | 0 | 73 | 182 |
| | 60 | 222 | 390 |
| | 120 | 346 | 532 |
| | | | |
| 0.2% Ceria-coated Silica + 0.28% Lactitol pH 8.0 | 0 | 269 | 386 |
| | 60 | 425 | 576 |
| | 120 | 568 | 766 |

Table 27 depicts the ratio of Trench Dishing Rate (A)/Blanket HDP RR (A/min.) at Different pH.

**Table 27. Ratio of Trench Dishing Rate (A)/Blanket HDP RR (A/min.) at Different pH**

| Compositions | **P100 Dishing Rate (Å/min.) /Blanket HDP RR (A/min.)** | **P200 Dishing Rate (Å/min.) /Blanket HDP RR (A/min.)** |
|---|---|---|
| 0.2% Ceria-coated Silica pH 5.35 | 0.13 | 0.16 |
| 0.2% Ceria-coated Silica + 0.28% Lactitol pH 5.35 | 0.03 | 0.03 |
| 0.2% Ceria-coated Silica + 0.28% Lactitol pH 7.0 | 0.05 | 0.06 |
| 0.2% Ceria-coated Silica + 0.28% Lactitol pH 8.0 | 0.06 | 0.08 |

As the results in Table 27 show, the addition of lactitol as oxide trench dishing reducer in polishing composition significantly reduced the ratio of trench dishing rate vs the blanket HDP film removal rates at different pH conditions compared to the ratio obtained for reference sample at pH 5.35.

The slopes of oxide trench dishing vs the OP removal amount at different pH conditions is shown in Table 28.

**Table 28. Effects of Lactitol at Different pH on Slopes of Dishing vs OP Removal Amount**

| Compositions | **P100 dishing/OP Amt Slope** | **P200 dishing/OP Amt Slope** |
|---|---|---|
| 0.2% Ceria-coated Silica pH 5.35 | 0.19 | 0.23 |
| 0.2% Ceria-coated Silica + 0.28% Lactitol pH 5.35 | 0.04 | 0.06 |
| 0.2% Ceria-coated Silica + 0.28% Lactitol pH 7.0 | 0.06 | 0.08 |
| 0.2% Ceria-coated Silica + 0.28% Lactitol pH 8.0 | 0.06 | 0.08 |

The results listed in Table 28 indicate that the compositions with chemical additive lactitol at different pH conditions provided lower slopes of trench dishing vs the over polishing removal amounts which indicates a good over polishing window for maintaining low oxide trench dishing even when more oxide film is removed in over polishing steps.

As shown in Table 28, lactitol and ceria-coated silica based CMP polishing compositions again showed much lower slope values at different pH conditions comparing to those slope values obtained for the ceria-coated silica abrasive based reference sample at pH 5.35.

In Example 11, the trench oxide loss rates were compared for the polishing compositions using lactitol at different pH conditions or without using lactitol at pH 5.35 and listed in Table 29.

**Table 29. Effects of Lactitol at Different pH Conditions on Trench Loss Rates (A/min.)**

| Compositions | P100Trench Loss Rate (Å/sec.) | P200Trench Loss Rate (Å/sec.) |
|---|---|---|
| 0.2% Ceria-coated Silica pH 5.35 Ref. | 18.5 | 19.3 |
| 0.2% Ceria-coated Silica + 0.28% Lactitol pH 5.35 | 2.3 | 2.6 |
| 0.2% Ceria-coated Silica + 0.28% Lactitol pH 7.0 | 3.3 | 4.0 |
| 0.2% Ceria-coated Silica + 0.28% Lactitol pH 8.0 | 3.7 | 4.2 |

As the results in Table 29 show, the addition of lactitol as an oxide trench dishing reducing agent into the polishing compositions at different pH conditions significantly reduces the trench loss rates as compared to the reference sample without using lactitol as chemical additive.

The polishing test results obtained at different pH conditions using lactitol as oxide trench dishing reducer proved that the CMP polishing compositions can be used in wide pH range including acidic, neutral or alkaline pH conditions.

### Example 12

When using suitable chemical additives, such as maltitol or lactitol or their derivatives, as oxide trench reducing agents in polishing compositions, these chemical additives can have some impact on the stability of ceria-coated inorganic oxide abrasives in the CMP polishing compositions. In CMP polishing compositions, it is very important to have good abrasive particle stability to assure constant and desirable CMP polishing performances.

Typically, the abrasive particle stability is tested through monitoring the MPS (nm) (=mean particle size) and D99(nm) changes over time or at elevated temperatures. The smaller of MPS (nm) and D99(nm) changes, the more stable the invented polishing compositions are.

In this example, the stability of ceria-coated silica abrasive particles in the compositions having chemical additives was monitored by measuring the change of the mean particles size and the change of particle size distribution D99.

The testing samples were made using 0.2 wt.% or other wt.% ceria-coated silica abrasive; very low concentration of biocide; 0.15 wt.% maltitol, 0.15 wt.% lactitol or 0.0787 wt.% Myo-inositol as oxide trench dishing reducer; and with pH adjusted to 5.35.

The abrasive stability tests on the polishing compositions were carried out at 50 °C for at least 10 days or more.

The MPS (nm) or D99(nm) of the tested polishing compositions were measured using DLS technology (DLS = dynamic light scattering).

The stability test results of the used ceria-coated silica abrasives with the chemical additives are listed in Table 30.

**Table 30. Particle Size Stability (MPS) Test Results@50 °C - D99(nm)**

| Compositions/Days | 0 | 1 | 2 | 3 | 4 | 11 | 18 | 32 |
|---|---|---|---|---|---|---|---|---|
| 0.2% Ceria-coated Silica + 0.15% Maltitol | 179.6 | 179.6 | 178.4 | 179.6 | 180 | | 183 | |
| 0.2% Ceria-coated Silic+0.15% Lactitol | 180 | 178.8 | 180.9 | 179.6 | 180.6 | | | 182.3 |
| 0.2% Ceria-coated Silic + 0.0787% Myo-Inositol | 180.8 | 178.5 | 179.6 | 180.4 | 181.5 | 182.3 | | |

By day 4 at 50 °C, 0.2 wt. % ceria-coated silica particles had MPS changes of 0.23%, 0.34% and 0.39% in the compositions having 0.15 wt. % maltitol, 0.15 wt. % lactitol and 0.0787 wt.% myo-inositol respectively.

0.2 wt. % ceria-coated silica particles in the composition having 0.15 wt. % maltitol had a mean particle size change of less than 1.9 % by day 18 at 50 °C.

0.2 wt. % ceria-coated silica particles in the composition having 0.0787 wt.% myo-inositol had a mean particle size change of less than 0.83 % by day 11 at 50 °C.

0.2 wt. % ceria-coated silica particles in the composition having 0.15 wt.% lactitol had a mean particle size change of less than1.3 % by day 32 at 50 °C.

More stability tests are listed in Table 31.

**Table 31. Particle Size Stability Test Results@50 °C - MPS (nm) & D99(nm)**

| Compositions | Particle Sizes (nm) | Day 0 | Day 1 | Day 4 | Day 8 | Day 15 | Day 22 | Day 33 | Day 40 | Day 62 |
|---|---|---|---|---|---|---|---|---|---|---|
| 0,2% Ceria-coated Silica + 0,15% Maltitol pH 5.35 | MPS(nm) | 120 | 121.1 | 122.8 | 123 | 123.2 | 121.5 | 121.9 | 120.6 | 119.9 |
| | D99(nm) | 176.3 | 178 | 180.9 | 180.4 | 180 | 172.4 | 178.3 | 176.2 | 177.4 |

0.2 wt. % ceria-coated silica particles in the composition having 0.15 wt.% maltitol had a mean particle size and D99 changes of less than 8.34x10⁻⁴ and 0.63 % respectively by day 62 at 50 °C.

Furthermore, the particle stability tests were also conducted at 50 °C on polishing compositions comprising more concentrated ceria-coated silica abrasives ( more than 0.2 wt. %) and more concentrated maltitol (more than 0.15 wt. %) as oxide trench dishing reducer.

The test results are listed in Table 32.

Data showed that 0.8 wt. % of the ceria-coated silica particles had MPS and D99 changes of less than 0.41 % and less than 0.23 % respectively by day 42 at 50 °C in the composition having 0.6 wt. % of maltitol respectively.

**Table 32. Particle Size Stability Test Results@50 °C - MPS (nm) & D99(nm)**

| Compositions | Particle (nm) Sizes | Day 0 | Day 3 | Day 5 | Day 7 | Day 14 | Day 19 | Day 25 | Day42 |
|---|---|---|---|---|---|---|---|---|---|
| 0.8% Ceria-coated Silica + 0.6% Maltitol pH 5.35 | MPS(nm) | 122 | 122 | 121.9 | 122 | 121 | 121 | 121.4 | 122.5 |
| | D99(nm) | 180.5 | 179.5 | 180 | 179.6 | 185.3 | 185.3 | 179.6 | 180.9 |
| 1.6% Ceria-coated Silica + 1.2% Maltitol pH 5.35 | MPS(nm) | 121.2 | 122.1 | 122.1 | 121.5 | 121.3 | 121.2 | 121.4 | 122.6 |
| | D99(nm) | 179.5 | 180 | 180 | 179.2 | 179.6 | 179.6 | 180.5 | 182.3 |
| 2.4% Ceria-coated Silica + 1.8% Maltitol pH 5.35 | MPS(nm) | 122.1 | 121.9 | 121.5 | 121.1 | 121 | 121 | 122 | 122.5 |
| | D99(nm) | 180.5 | 180 | 179.2 | 178 | 180.1 | 180.1 | 180.5 | 180.9 |

Data also showed that 0.8 wt. % of the ceria-coated silica particles had MPS and D99 changes of less than 0.41 % and less than 0.23 % respectively by day 42 at 50 °C in the composition having 0.6 wt. % of maltitol respectively.

1.6 wt. % of the ceria-coated silica particles had MPS and D99 changes of less than 1.2% and less than 1.6 % respectively by day 42 at 50 °C in the composition having 1.2 wt. % of maltitol respectively..

2.4 wt. % of the ceria-coated silica particles had MPS and D99 changes of less than 0.33 % and less than 0.23 % respectively by day 42 at 50 °C in the composition having 1.8 wt. % of maltitol respectively.

As the results in Tables 30 to 32 show, when maltitol, lactitol or Myo-inositol is used as an oxide trench dishing reducer with ceria-coated silica particles as abrasives, the polishing compositions show very good particle size stability of MPS(nm) and D99(nm) even at elevated testing temperatures.

The polishing compositions comprised of ceria-coated colloidal silica abrasives and more concentrated maltitol as oxide trench dishing reducer all showed very good particle size stability of MPS (nm) and D99(nm) at elevated temperatures.

### Example 13

Another key benefit of using the presently invented CMP polishing compositions is the reduced total defect counts through and post-polishing resulting from using the ceria-coated colloidal silica composite particles as abrasives instead of using calcined ceria particle as abrasives.

The following three polishing compositions were prepared for defects testing. The first sample was made using 0.5 wt.% calcined ceria abrasives, 0.05 wt.% polyacrylate salt and low concentration of biocide; the second sample was made using 0.2 wt.% ceria-coated silica abrasives, 0.28 wt.% maltitol and low concentration of biocide; the third sample was made using 0.2 wt.% ceria-coated silica abrasives, 0.28 wt.% lactitol and low concentration of biocide. In order to allow similar dielectric film removal rates to be compared, higher concentration of calcinated ceria abrasive was used in sample 1.

All three formulations have pH valued at 5.35.

The total defect counts on polished TEOS and SiN wafers was compared by using three afore listed polishing compositions. The total defect count results are listed in Table 33.

As the total defect count results in Table 33 show, the polishing compositions using ceria-coated silica particles as abrasives and either of maltitol or lactitol as trench dishing reducing agent provided significantly lower total defect counts on the polished TEOS and SiN wafers than the total defect counts obtained using the polishing composition comprised of calcined ceria abrasives and polyacrylate salt as chemical additive.

**Table 33. Effects of Different Polishing Compositions on TEOS & SiN Total Defect Counts**

| Compostions | TEOS Total Defect Count@0.13µm LPD | SiN Total Defect Count@0.13µm LPD |
|---|---|---|
| 0.2% Calcined Ceria + 0.05% Polyacrylate Salt pH 5.35 | 3847 | 498 |
| 0.2% Ceria-coated Silica + 0.28% Maltitol pH 5.35 | 438 | 73 |
| 0.2% Ceria-coated Silica + 0.28% Lactitol pH 5.35 | 493 | 73 |

### Example 14

The following four polishing compositions were prepared for the defects testing.

The first two polishing compositions used calcined ceria abrasives, 0.28 wt.% maltitol or 0.28 wt.% lactitol as oxide trenching dishing reducing agent and low concentration of biocide; the other two polishing compositions were made using ceria-coated silica abrasives, 0.28 wt.% maltitol or 0.28 wt.% lactitol as oxide trenching dishing reducing agent and low concentration of biocide. All four formulations have pH valued at 5.35.

All chemical additives were used at the same wt.%, but different types of abrasives were used, e.g., calcined ceria vs ceria-coated silica particles as abrasives.

The effects of different types of abrasives on the film removal rates and TEOS: SiN selectivity were observed and the results listed in table 34.

**Table 34. Effects of Different Types of Abrasives on Film RR & TEOS: SiN Selectivity**

| Compositions | TEOS RR (A/min. | HDP RR (A/min.) | SiN RR (A/min.) | TEOS: SiN Selectivity |
|---|---|---|---|---|
| Calcined Ceria + 0.28% Maltitol | 1774 | 1839 | 38 | 43 |
| Calcined Ceria + 0.28% Lactitol | 1997 | 1996 | 37 | 54 |
| Ceria-coated Silica + 0.28% Maltitol | 3085 | 2956 | 60 | 51 |
| Ceria-coated Silica + 0.28% Lactitol | 3188 | 2885 | 69 | 46 |

As the results in Table 34 show, the polishing compositions that used ceria-coated silica as abrasives did afford much higher TEOS and HDP film removal rates than those film removal rates obtained from the polishing compositions which used calcined ceria as abrasives.

The normalized total defect counts on polished TEOS and SiN wafers were compared by using four afore listed polishing compositions. The normalized total defect count results are listed in Table 35.

**Table 35. Effects of Different Types of Abrasives on Normalized TEOS & SiN Total Defect Counts**

| Compositions | TEOS 0.07um LPD | TEOS 0.13um LPD | PECVD SiN 0.1um LPD | PECVD SiN 0.13um LPD |
|---|---|---|---|---|
| Calcined Ceria + 0.28% Maltitol | 1.00 | 1.00 | 1.00 | 1.00 |
| Calcined Ceria + 0.28% Lactitol | 1.03 | 0.64 | 0.96 | 1.04 |
| Ceria-coated Silica + 0.28% Maltitol | 0.21 | 0.07 | 0.25 | 0.58 |
| Ceria-coated Silica + 0.28% Lactitol | 0.43 | 0.10 | 0.49 | 0.58 |

As the normalized total defect count results in Table 35 show, the polishing compositions using ceria-coated silica particles as abrasives and either maltitol or lactitol as trench dishing reducing agent afforded significantly lower normalized total defect counts on the polished TEOS and SiN wafers than the normalized total defect counts obtained using the polishing composition comprised of calcined ceria abrasives, and either maltitol or lactitol as oxide trench dishing reducing chemical additive.

The embodiments of this invention listed above, including the working example, are exemplary of numerous embodiments that may be made of this invention. It is contemplated that numerous other configurations of the process may be used, and the materials used in the process may be elected from numerous materials other than those specifically disclosed.

The present invention includes the following Aspects 1 to 32
Aspect 1. A Chemical Mechanical Polishing(CMP) composition comprising:
   abrasive particles selected from the group consisting of ceria-coated inorganic oxide particles selected from the group consisting of ceria-coated colloidal silica, ceria-coated high purity colloidal silica, ceria-coated alumina, ceria-coated titania, ceria-coated zirconia particles and combinations thereof; ceria-coated organic polymer particles selected from the group consisting of ceria-coated polystyrene particles, ceria-coated polyurethane particle, ceria-coated polyacrylate particles, and combinations thereof; and
   combinations thereof;
   chemical additive;
   solvent selected from the group consisting of deionized (DI) water, distilled water, and alcoholic organic solvents; and
   optionally
   biocide; and
   pH adjuster;
   wherein
   the composition has a pH of 2 to 12; and
   the chemical additive is selected from the group consisting of
      (A) a molecular structure (a): 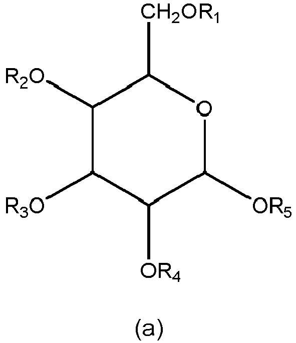 wherein R1, R2, R3, R4 and R5 (Rs in group of R1 to R5) are selected from the group consisting of
         (1)
            (i)at least one R in the group of R1 to R5 is a polyol molecular unit having a structure shown in (b): 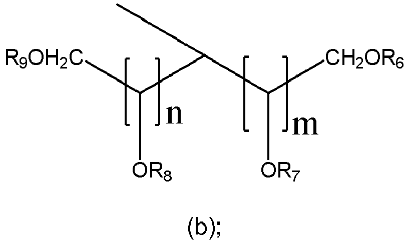 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
               and
            (ii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and
               combinations thereof;
               and
         (2)
            (i) at least one R in the group of R1 to R5 is a polyol molecular unit having a structure shown in (b): 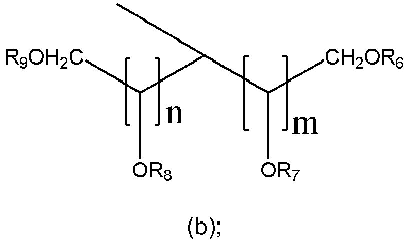 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
            (ii) at least one R in the group of R1 to R5 is a six-member ring polyol as shown in (c): 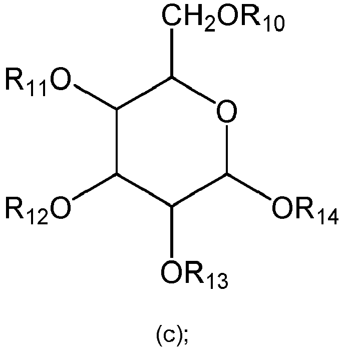
               Wherein one of OR in group of OR11, OR12, OR13 and OR14 will be replaced by O in structure (a); and
               R10 and each of other R in group of R10, R11, R12, R13 and R14 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
               and
            (iii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
      (B)a molecular structure selected from the group consisting of at least one (d), at least one (e), at least one (f), at least one (g), at least one (h), and combinations thereof; 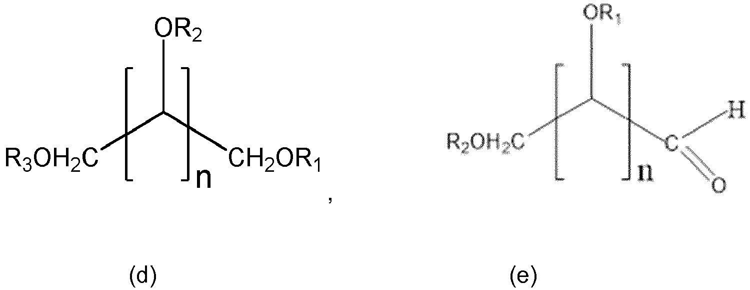 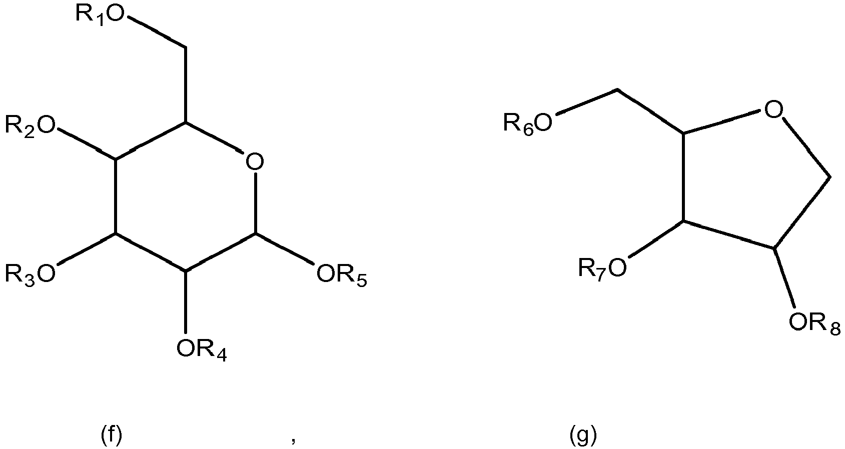 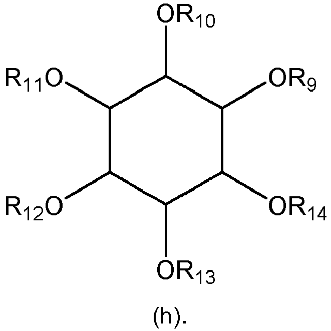
         wherein n is selected from 3 to 12;
         R1, R2, R3, R4, R5, R6, R7 R8, R9, R10, R11, R12, R13, and R14 can be the same or different atoms or functional groups; and each R is independently selected from the group consisting of hydrogen, oxygen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; wherein, at least four of them are hydrogen atoms.
Aspect 2. The Chemical Mechanical Polishing(CMP) composition of Aspect #1, wherein
   the abrasive particles range from 0.05 wt.% to 10 wt.% and have mean particle size ranging from 5nm to 500nm;
   the chemical additive ranges from 0.01 wt.% to 20.0% wt.% and has at least four hydroxyl functional groups in its molecular structure; and
   the composition has a pH of 3 to 10.
Aspect 3. The Chemical Mechanical Polishing(CMP) composition of Aspect #2, wherein
   the abrasive particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under.
Aspect 4. The Chemical Mechanical Polishing(CMP) composition of Aspect 1, wherein
   the abrasive particles having mean particle size ranging from 5nm to 500nm, and have a concentration from 0.05 wt.% to 10 wt.%;
   the chemical additive (a) has at least six hydroxyl functional groups in its molecular structure and R1, R2, R3, R4 and R5 (Rs in group R1 to R5) selected from (1), and ranges from 0.05 wt.% to 5 wt.%;
   the composition has a pH of 3 to 10; and
   the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under.
Aspect 5. The Chemical Mechanical Polishing(CMP) composition of Aspect 4, wherein
   the polyol molecular unit (b) has n = 2 and m =1; and rest of Rs in the group of R1 to R9 are all hydrogen atoms, as shown below: 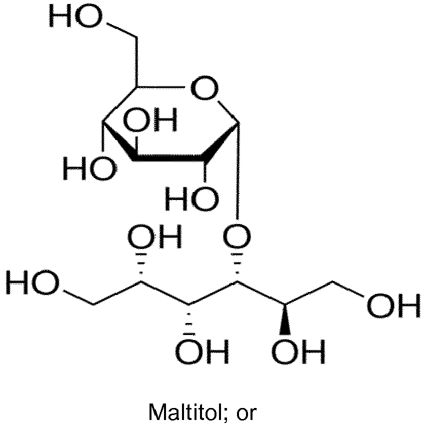 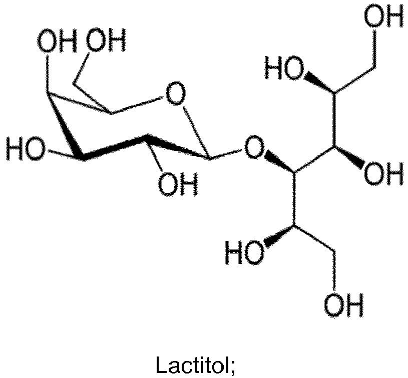 the solvent is deionized (DI) water; and
   the ceria-coated colloidal silica particles have changes of mean particle size MPS(nm) and D99(nm) ≤ 2.0%.
Aspect 6. The Chemical Mechanical Polishing(CMP) composition of Aspect 1, wherein
   the abrasive particles having mean particle size ranging from 5nm to 500nm, and have a concentration from 0.05 wt.% to 10 wt.%; the chemical additive (a) has at least six hydroxyl functional groups in its molecular structure and R1, R2, R3, R4 and R5 (Rs in group R1 to R5) selected from (2), and range from 0.05 wt.% to 5 wt.%;
   the composition has a pH of 3 to 10; and
   the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under.
Aspect 7. The Chemical Mechanical Polishing(CMP) composition of Aspect 6, wherein
   the polyol molecular unit (b) which has n = 2 and m =1; and rest of Rs in the group of R1 to R14 are all hydrogen atoms, as shown below: 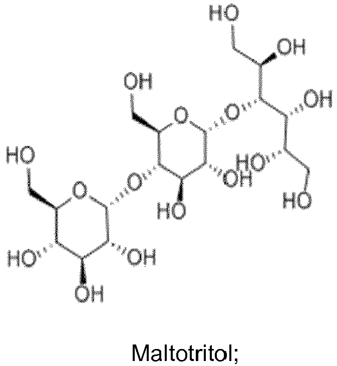 and the solvent is deionized (DI) water, and
   the ceria-coated colloidal silica particles have changes of mean particle size MPS(nm) and D99(nm) ≤ 2.0%.
Aspect 8. The Chemical Mechanical Polishing(CMP) composition of Aspect 1, wherein
   the abrasive particles range from 0.05 wt.% to 10 wt.% and have mean particle size ranging from 5nm to 500nm;
   the chemical additive ranges from 0.01 wt.% to 20.0% wt.% and is selected from the group comprising maltitol, lactitol, maltotritol, ribitol, D-sorbitol, mannitol, dulcitol, iditol, D- (-)-Fructose, sorbitan, sucrose, Inositol, glucose, D-arabinose, L-arabinose, L-mannose, D-mannose, L-mannose, meso-erythritol, ribose, beta-lactose, and combinations thereof.
   the composition has a pH of 3 to 10.
Aspect 9. The Chemical Mechanical Polishing(CMP) composition of Aspect 1, wherein
   the abrasive particles are ceria-coated colloidal silica particles having mean particle size ranging from 5nm to 500nm, and have a concentration from 0.05 wt.% to 10 wt.%;
   the chemical additive ranges from 0.05 wt.% to 5 wt.%, and is selected from the group comprising maltitol, lactitol, maltotritol, D-sorbitol, mannitol, dulcitol, iditol, D- (-)-Fructose, sucrose, Inositol, glucose, L-mannose, D-mannose, beta-lactose, and combinations thereof.
   the composition has a pH of 3 to 10; and
   the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under.
Aspect 10. The chemical mechanical polishing composition of Aspect 1, wherein the composition comprises ceria-coated colloidal silica particles having mean particle size ranging from 5nm to 500nm, and have a concentration from 0.05 wt.% to 10 wt.%;
   the chemical additive selected from the group consisting of maltitol, lactitol, maltotritol, D-sorbitol, mannitol, dulcitol, D- (-)-Fructose, beta-lactose, and combinations thereof; and
   the ceria-coated colloidal silica particles have changes of mean particle size MPS(nm) and D99(nm) ≤ 2.0% over shelf time of ≥ 30 days at a temperature ranging from 20 to 60 °C; wherein D99(nm) is a particle size that 99 wt.% of the particles fall on and under.
Aspect 11. The chemical mechanical polishing composition of Aspect 1, wherein the composition comprises one selected from the group consisting of from 0.0001 wt.% to 0.05 wt.% of the biocide having active ingredient selected from the group consisting of 5-chloro-2-methyl-4-isothiazolin-3-one, 2-methyl- 4-isothiazolin-3-one,and combinations thereof; from 0 wt.% to 1 wt.% of the pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydroxide, potassium hydroxide, ammonium hydroxide, tetraalkyl ammonium hydroxide, organic quaternary ammonium hydroxide compounds, organic amines, and combinations thereof for alkaline pH conditions; and combinations thereof.
Aspect 12. A method of chemical mechanical polishing (CMP) a semiconductor substrate having at least one surface comprising silicon oxide film, comprising
   (a)providing the semiconductor substrate;
   (b)providing a polishing pad;
   (c)providing a chemical mechanical polishing (CMP) composition comprising 0.
      05 wt.% to 10 wt.% abrasive particles selected from the group consisting of ceria-coated inorganic oxide particles selected from the group consisting of ceria-coated colloidal silica, ceria-coated high purity colloidal silica, ceria-coated alumina, ceria-coated titania, ceria-coated zirconia particles and combinations thereof;
         ceria-coated organic polymer particles selected from the group consisting of ceria-coated polystyrene particles, ceria-coated polyurethane particle, ceria-coated polyacrylate particles, and combinations thereof; and
         combinations thereof;
      0.01 wt.% to 20.0% wt.% chemical additive;
      solvent selected from the group consisting of deionized (DI) water, distilled water, and alcoholic organic solvents; and
      optionally
      biocide; and
      pH adjuster;
      wherein
      the composition has a pH of 2 to 12; and
      the chemical additive is selected from the group consisting of
         (A)a molecular structure (a): 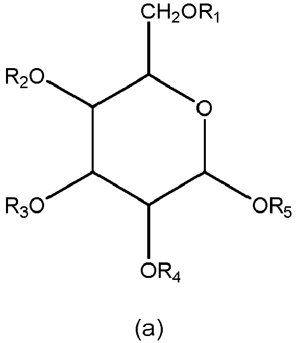 wherein R1, R2, R3, R4 and R5 (Rs in group of R1 to R5) are selected from the group consisting of
            (1)
               (i)at least one R in the group of R1 to R5 is a polyol molecular unit having a structure shown in (b): 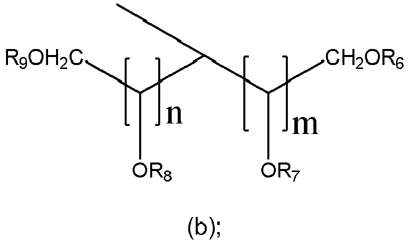 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
                  and
               (ii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
                  and
            (2)
               (i)at least one R in the group of R1 to R5 is a polyol molecular unit having a structure shown in (b): 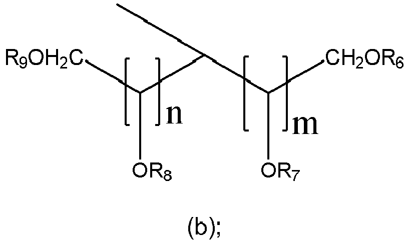 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
               (ii)at least one R in the group of R1 to R5 is a six-member ring polyol as shown in (c): 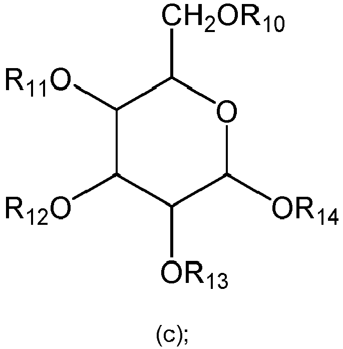
                  wherein one OR in group of OR11, OR12, OR13 and OR14 will be replaced by O in structure (a); and
                  R10 and each of other R in group of R10, R11, R12, R13 and R14 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof; and
               (iii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
         (B)a molecular structure selected from the group consisting of at least one (d), at least one (e), at least one (f), at least one (g), at least one (h) and combinations thereof;

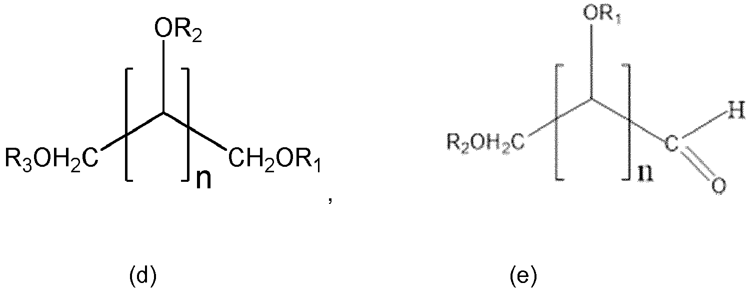

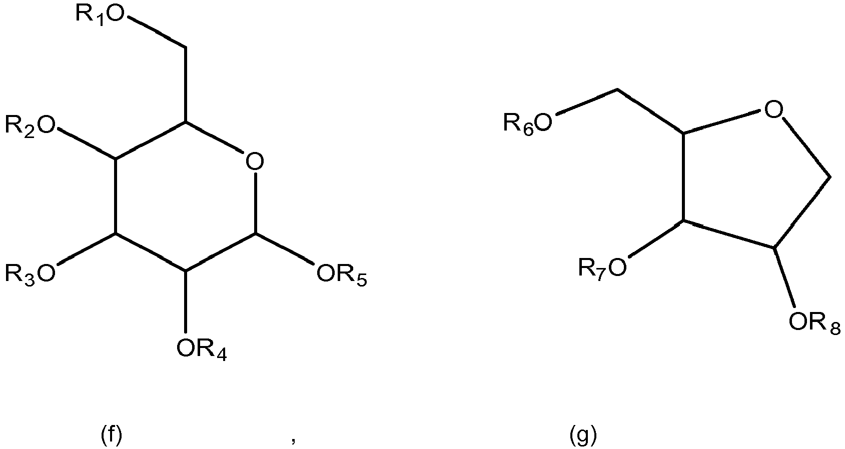

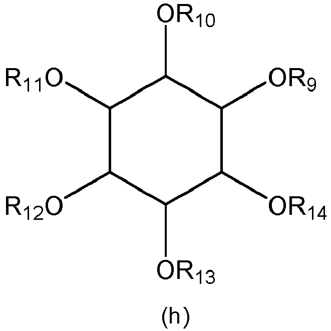

         wherein n is selected from 3 to 12;
         R1, R2, R3, R4, R5, R6, R7 R8, R9, R10, R11, R12, R13, and R14 can be the same or different atoms or functional groups; and each R is independently selected from the group consisting of hydrogen, oxygen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; wherein, at least four of them are hydrogen atoms;
   (d)contacting the surface of the semiconductor substrate with the polishing pad and the chemical mechanical polishing composition; and
   (e)polishing the least one surface comprising silicon dioxide film;
      wherein the silicon oxide film is selected from the group consisting of Chemical vapor deposition (CVD), Plasma Enhance CVD (PECVD), High Density Deposition CVD(HDP), spin on silicon oxide film, flowable CVD oxide film, carbon doped oxide film, nitrogen doped oxide film, and combinations thereof.
Aspect 13. The method of Aspect 12; wherein the chemical mechanical polishing (CMP) composition comprises
   the abrasive particles having mean particle size ranging from 5nm to 500nm;
   wherein the ceria-coated inorganic oxide particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under;
   the chemical additive having at least four hydroxyl functional groups in its molecular structure; and
   the chemical mechanical polishing (CMP) composition has a pH of 3 to 10.
Aspect 14. The method of Aspect 12; wherein the chemical mechanical polishing (CMP) composition comprises
   the abrasive particles having mean particle size ranging from 5nm to 500nm;
   wherein the ceria-coated inorganic oxide particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under;
   the chemical additive (a) has at least six hydroxyl functional groups in its molecular structure and R1, R2, R3, R4 and R5 (Rs in group R1 to R5) selected from (1), and ranges from 0.05 wt.% to 5 wt.%; and
   the composition has a pH of 3 to 10.
Aspect 15. The method of Aspect 14, wherein
   the polyol molecular unit (b) in the chemical additive has n = 2 and m =1; and rest of Rs in the group of R1 to R9 are all hydrogen atoms, as shown below: 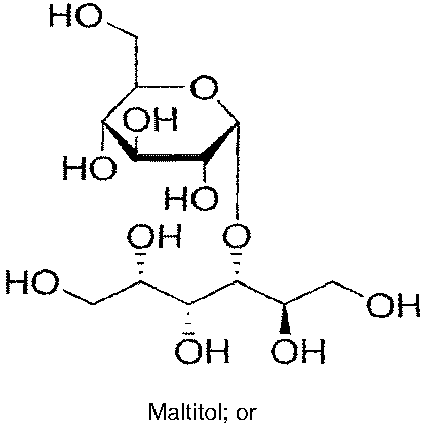 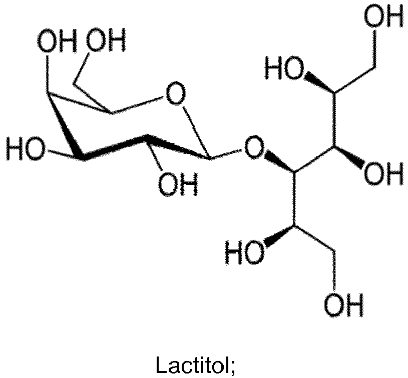 the solvent is deionized (DI) water;
   the ceria-coated colloidal silica particles have changes of mean particle size MPS(nm) and D99(nm) ≤ 2.0%; and
   ratio of oxide trench dishing rate (A/min.) vs the blanket HDP film removal rate(Å/min.) is ≤ 0.1.
Aspect 16. The method of Aspect 12; wherein the chemical mechanical polishing (CMP) composition comprises
   the abrasive particles ceria-coated colloidal silica particles or ceria particles having mean particle size ranging from 5nm to 500nm;
   the chemical additive has at least six hydroxyl functional groups in its molecular structure and R1, R2, R3, R4 and R5 (Rs in group R1 to R5) selected from (2); the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under; and
   the composition has a pH of 3 to 10.
Aspect 17. The method of Aspect 16, wherein
   the polyol molecular unit (b) in the chemical additive has n = 2 and m =1; and rest of Rs in the group of R1 to R14 are all hydrogen atoms, as shown below: 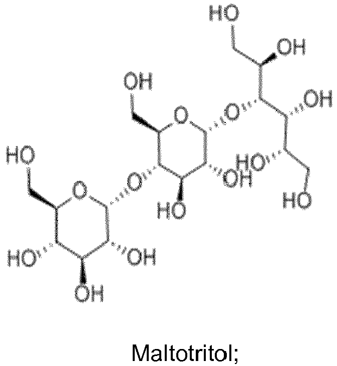 the solvent is deionized (DI) water;
   the ceria-coated colloidal silica have changes of mean particle size MPS(nm) and D99(nm) ≤ 2.0%; and
   ratio of oxide trench dishing rate (Å/min.) vs the blanket HDP film removal rate(Å/min.) is ≤ 0.1.
Aspect 18. The method of Aspect 12, wherein the chemical mechanical polishing (CMP) composition comprises
   the abrasive particles having mean particle size ranging from 5nm to 500nm; wherein the abrasive particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under;
   the chemical additive is selected from the group comprising maltitol, lactitol, maltotritol, ribitol, D-sorbitol, mannitol, dulcitol, iditol, D-(-)-Fructose, sorbitan, sucrose, Inositol, glucose, D-arabinose, L-arabinose, D-mannose, L-mannose, meso-erythritol, ribose, beta-lactose, and combinations thereof; and the composition has a pH of 3 to 10.
Aspect 19. The method of Aspect 12; wherein the chemical mechanical polishing (CMP) composition comprises
   ceria-coated colloidal silica particles having mean particle size ranging from 5nm to 500nm;
   wherein the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under;
   the chemical additive has at least five hydroxyl functional groups in its molecular structure; and is selected from the group comprising maltitol, lactitol, maltotritol, D-sorbitol, mannitol, dulcitol, iditol, D- (-)-Fructose, sucrose, ribose, Inositol, glucose. D-(+)-mannose, beta-lactose, and combinations thereof;
   water; and
   the composition has a pH of 3 to 10.
Aspect 20. The method of Aspect 12; wherein the chemical mechanical polishing (CMP) composition comprises
   ceria-coated colloidal silica particles having mean particle size ranging from 5nm to 500nm;
   wherein the ceria-coated colloidal silica particles have changes of mean particle size MPS(nm) and D99(nm) ≤ 2.0% over shelf time of ≥ 30 days at a temperature ranging from 20 to 60 °C; wherein D99(nm) is a particle size that 99 wt.% of the particles fall on and under;
   the chemical additive selected from the group consisting of maltitol, lactitol, maltotritol, D-sorbitol, mannitol, dulcitol, D-(-)-Fructose, beta-lactose, and combinations thereof; and water;
   the composition has a pH of 3 to 10.
Aspect 21. The method of Aspect 12, wherein the chemical mechanical polishing (CMP) composition comprises one selected from the group consisting of from 0.0001 wt.% to 0.05 wt.% of the biocide having active ingredient selected from the group consisting of 5-chloro-2-methyl-4-isothiazolin-3-one, 2-methyl- 4-isothiazolin-3-one,and combinations thereof; from 0 wt.% to 1 wt.% of the pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydroxide, potassium hydroxide, ammonium hydroxide, tetraalkyl ammonium hydroxide, organic quaternary ammonium hydroxide compounds, organic amines, and combinations thereof for alkaline pH conditions; and combinations thereof.
Aspect 22. The method of Aspect 12; wherein the semiconductor substrate further comprises a silicon nitride surface; and removal selectivity of silicon oxide: silicon nitride is ≥20.
Aspect 23. A system of chemical mechanical polishing (CMP) a semiconductor substrate having at least one surface comprising silicon oxide film, comprising
   a. the semiconductor substrate;
   b. a polishing pad; and
   c. a chemical mechanical polishing (CMP) composition comprising
      0.05 wt.% to 10 wt.% 0.05 wt.% to 10 wt.% abrasive particles selected from the group consisting of
         ceria-coated inorganic oxide particles selected from the group consisting of ceria-coated colloidal silica, ceria-coated high purity colloidal silica, ceria-coated alumina, ceria-coated titania, ceria-coated zirconia particles and combinations thereof;
         ceria-coated organic polymer particles selected from the group consisting of ceria-coated polystyrene particles, ceria-coated polyurethane particle, ceria-coated polyacrylate particles, and combinations thereof; and combinations thereof;
      0.01 wt.% to 20.0% wt.% chemical additive;
      solvent selected from the group consisting of deionized (DI) water, distilled water, and alcoholic organic solvents; and
      optionally
      biocide; and
      pH adjuster;
      wherein
      the composition has a pH of 2 to 12; and
      the chemical additive has at least four hydroxyl functional groups and is selected from the group consisting of
         (A) a molecular structure (a): 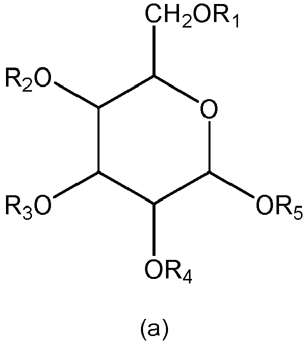 wherein R1, R2, R3, R4 and R5 (Rs in group of R1 to R5) are selected from the group consisting of
            (1)
               (i) at least one R in the group of R1 to R5 is a polyol molecular unit having a structure shown in (b): 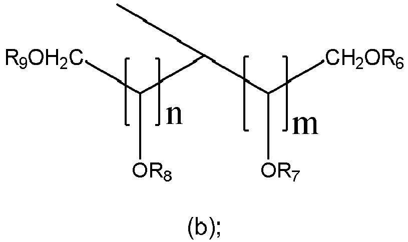 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
                  and
               (ii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
               and
            (2)
               (i) at least one R in the group of R1 to R5 is a polyol molecular unit having a structure shown in (b): 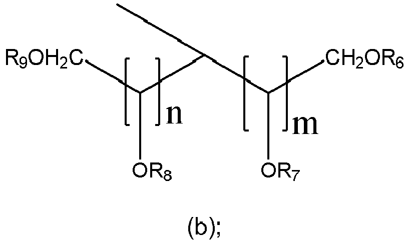 wherein m or n is independently selected from 1 to 5; and each of R6, R7, R8 and R9 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
               (ii) at least one R in the group of R1 to R5 is a six-member ring polyol as shown in (c): 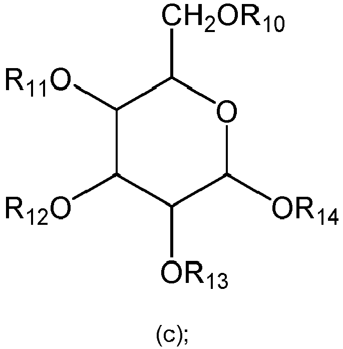
                  wherein one of OR in group of OR11, OR12, OR13 and OR14 will be replaced by O in structure (a); and
                  R10 and each of other R in group of R10, R11, R12, R13 and R14 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof; and
               (iii)each of other Rs in the group of R1 to R5 is independently selected from the group consisting of hydrogen, alkyl, alkoxy, organic group with one or more hydroxyl groups, substituted organic sulfonic acid or salt, substituted organic carboxylic acid or salt, organic carboxylic ester, organic amine, and combinations thereof;
         (B) a molecular structure selected from the group consisting of at least one (d), at least one (e), at least one (f), at least one (g), at least one (h) and combinations thereof; 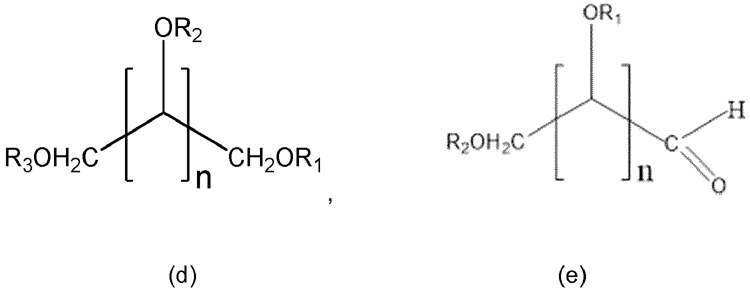 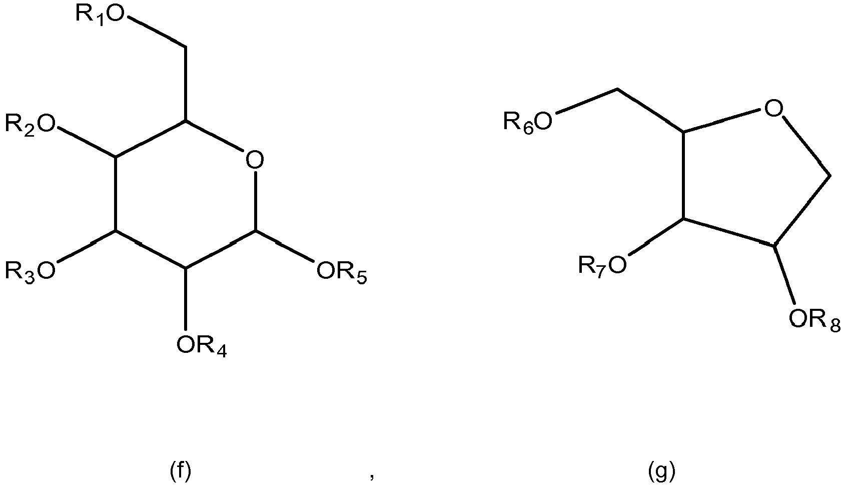 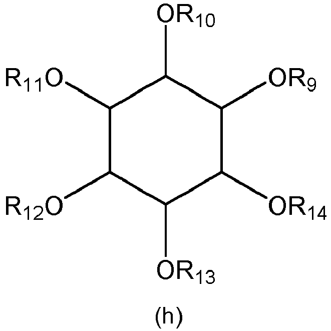 wherein n is selected from 3 to 12;
            R1, R2, R3, R4, R5, R6, R7 R8, R9, R10, R11, R12, R13, and R14 can be the same or different atoms or functional groups; and each R is independently selected from the group consisting of hydrogen, oxygen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; wherein, at least four of them are hydrogen atoms;
            wherein
            the silicon oxide film is selected from the group consisting of Chemical vapor deposition (CVD), Plasma Enhance CVD (PECVD), High Density Deposition CVD(HDP), spin on silicon oxide film, flowable CVD oxide film, carbon doped oxide film, ,nitrogen doped oxide film, and combinations thereof; and
            the at least one surface comprising silicon oxide film is in contact with the polishing pad and the chemical mechanical polishing composition.
Aspect 24. The system of Aspect 23; wherein the chemical mechanical polishing (CMP) composition comprises
   the abrasive particles having mean particle size ranging from 5nm to 500nm;
   wherein the c particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under;
   the chemical additive having at least four hydroxyl functional groups in its molecular structure;
   the chemical mechanical polishing (CMP) composition has a pH of 3 to 10.
Aspect 25. The system of Aspect 23; wherein the chemical mechanical polishing (CMP) composition comprises
   the abrasive particles having mean particle size ranging from 5nm to 500nm;
   wherein the abrasive particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under;
   the chemical additive (a) has at least six hydroxyl functional groups in its molecular structure and R1, R2, R3, R4 and R5 (Rs in group R1 to R5) selected from (1), and ranges from 0.05 wt.% to 5 wt.%; and
   the composition has a pH of 3 to 10.
Aspect 26. The system of Aspect 25, wherein
   the polyol molecular unit (b) in the chemical additive has n = 2 and m =1; and rest of Rs in the group of R1 to R9 are all hydrogen atoms, as shown below: 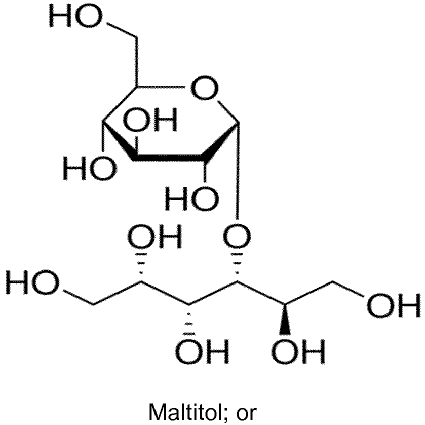 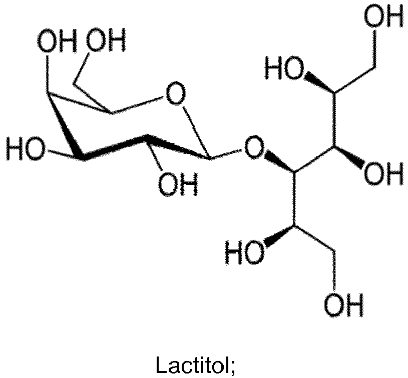 the solvent is deionized (DI) water; and
   the ceria-coated colloidal silica particles have changes of mean particle size MPS(nm) and D99(nm) ≤ 2.0%.
Aspect 27. The system of Aspect 23; wherein the chemical mechanical polishing (CMP) composition comprises
   the abrasive particles are ceria-coated colloidal silica particles having mean particle size ranging from 5nm to 500nm;
   wherein the abrasive particles have changes of mean particle size MPS(nm) and D99(nm) ≤ 5.0% over shelf time of ≥ 30 days at a temperature ranging from 20 to 60 °C; wherein D99(nm) is a particle size that 99 wt.% of the particles fall on and under;
   the chemical additive (a) has at least six hydroxyl functional groups in its molecular structure and R1, R2, R3, R4 and R5 (Rs in group R1 to R5) selected from (2); and the composition has a pH of 3 to 10.
Aspect 28. The system of Aspect 27; wherein
   the polyol molecular unit (b) in the chemical additive has n = 2 and m =1; and rest of Rs in the group of R1 to R14 are all hydrogen atoms, as shown below: 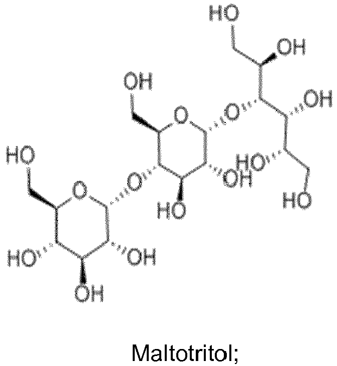 and the solvent is deionized (DI) water, and
   the ceria-coated colloidal silica particles have changes of mean particle size MPS(nm) and D99(nm) ≤ 2.0%; and
   ratio of oxide trench dishing rate (Å/min.) vs the blanket HDP film removal rate(Å/min.) is ≤ 0.1.
Aspect 29. The system of Aspect 23; wherein the chemical mechanical polishing (CMP) composition comprises
   the abrasive particles having mean particle size ranging from 5nm to 500nm;
   wherein the abrasive particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under;
   the chemical additive is selected from the group comprising maltitol, lactitol, maltotritol, ribitol, D-sorbitol, mannitol, dulcitol, iditol, D-(-)-Fructose, sorbitan, sucrose, Inositol, glucose, D-arabinose, L-arabinose, D-mannose, L-mannose, meso-erythritol, ribose, beta-lactose, and combinations thereof; and the composition has a pH of 3 to 10.
Aspect 30. The system of Aspect 23; wherein the chemical mechanical polishing (CMP) composition comprises
   ceria-coated colloidal silica particles having mean particle size ranging from 5nm to 500nm;
   wherein the ceria-coated colloidal silica particles have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under;
   the chemical additive has at least five hydroxyl functional groups in its molecular structure; and is selected from the group comprising maltitol, lactitol, maltotritol, D-sorbitol, mannitol, dulcitol, iditol, D- (-)-Fructose, sucrose, ribose, Inositol, glucose. D-(+)-mannose, beta-lactose, and combinations thereof;
   water;
   the composition has a pH of 3 to 10.
Aspect 31. The system of Aspect 23; wherein the chemical mechanical polishing (CMP) composition comprises
   ceria-coated colloidal silica particles having mean particle size ranging from 5nm to 500nm;
   wherein the ceria-coated colloidal silica particles have changes of mean particle size MPS(nm) and D99(nm) ≤ 2.0% over shelf time of ≥ 30 days at a temperature ranging from 20 to 60 °C; wherein D99(nm) is a particle size that 99 wt.% of the particles fall on and under;
   the chemical additive selected from the group consisting of maltitol, lactitol, maltotritol, D-sorbitol, mannitol, dulcitol, D- (-)-Fructose, , beta-lactose, and combinations thereof; and water;
   the composition has a pH of 3 to 10.
Aspect 32. The system of Aspect 23; wherein the chemical mechanical polishing (CMP) composition comprises one selected from the group consisting of from 0.0001 wt.% to 0.05 wt.% of the biocide having active ingredient selected from the group consisting of 5-chloro-2-methyl-4-isothiazolin-3-one, 2-methyl-4 -isothiazolin-3-one,and combinations thereof; from 0 wt.% to 1 wt.% of the pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydroxide, potassium hydroxide, ammonium hydroxide, tetraalkyl ammonium hydroxide, organic quaternary ammonium hydroxide compounds, organic amines, and combinations thereof for alkaline pH conditions; and combinations thereof.

## Claims

1. A Chemical Mechanical Polishing composition comprising:
abrasive particles selected from the group consisting of
ceria-coated inorganic oxide particles selected from the group consisting of ceria-coated colloidal silica, ceria-coated high purity colloidal silica, ceria-coated alumina, ceria-coated titania, ceria-coated zirconia particles and combinations thereof; ceria-coated organic polymer particles selected from the group consisting of ceria-coated polystyrene particles, ceria-coated polyurethane particle, ceria-coated polyacrylate particles, and combinations thereof; and
combinations thereof;
chemical additive; and
solvent selected from the group consisting of deionized (DI) water, distilled water,
and alcoholic organic solvents;
wherein
the composition has a pH of 2 to 12; and
the chemical additive is selected from the group consisting of
(A) compound with a molecular structure (a): 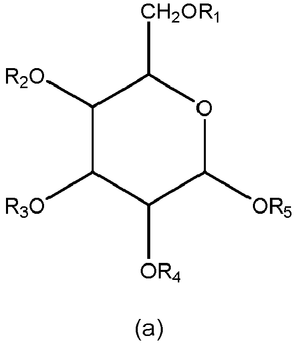 wherein either:
(1)
(i)at least one R in the group of R1 to R5 is a polyol molecular unit having a structure shown in (b): 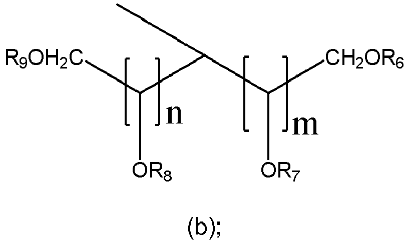 wherein m and n are each independently selected from 1 to 5; and each of R6, R7, R8 and R9 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
and
(ii)each of the other Rs in the group of R1 to R5 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
or
(2)
(i) at least one R in the group of R1 to R5 is a polyol molecular unit having a structure shown in (b): 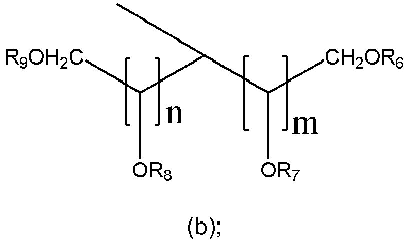 wherein m and n are each independently selected from 1 to 5; and each of R6, R7, R8 and R9 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
(ii) at least one R in the group of R1 to R5 is a six-member ring polyol as shown in (c): 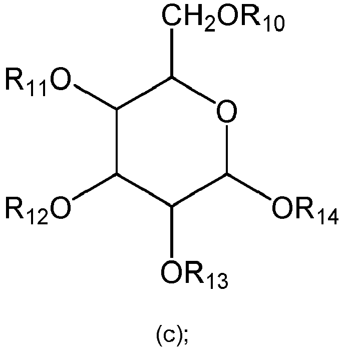 wherein
one OR in the group of OR11, OR12, OR13 and OR14 is replaced by O in structure (a); and
R10 and each of the other Rs in the group of R10, R11, R12, R13 and R14 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
and
(iii) each of the other Rs in the group of R1 to R5 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof;
(B) a molecular structure selected from the group consisting of at least one (d), at least one (e), at least one (f), at least one (g), at least one (h), and combinations thereof; 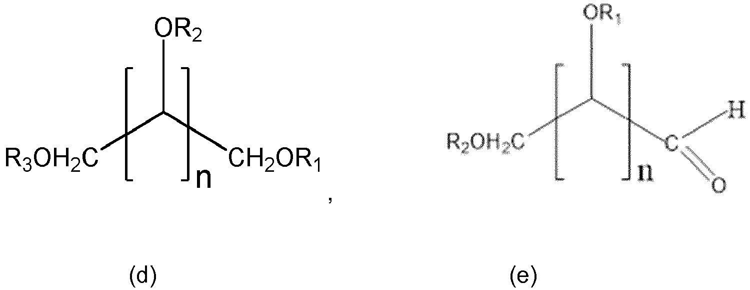 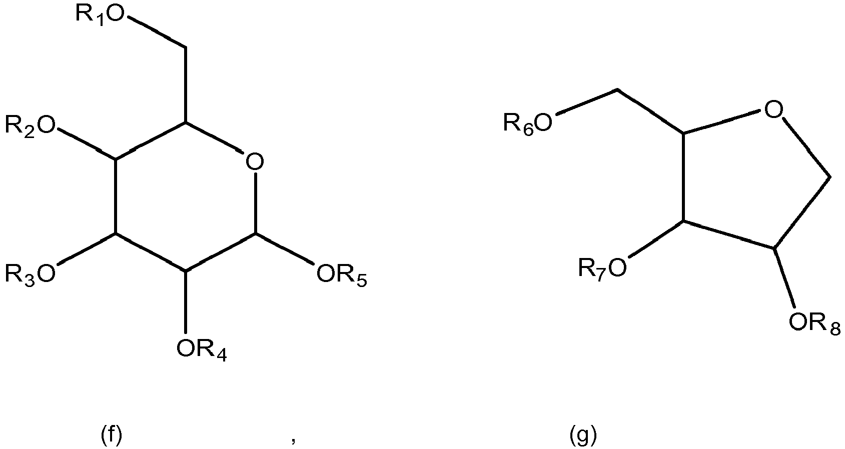 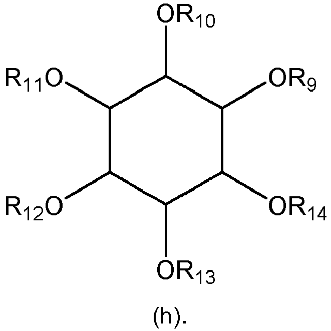
wherein n is selected from 3 to 12;
R1, R2, R3, R4, R5, R6, R7 R8, R9, R10, R11, R12, R13, and R14 can be the same or different atoms or functional groups; and each R is independently selected from the group consisting of hydrogen, oxygen, alkyl, alkoxy, an organic group with one or more hydroxyl groups, a substituted organic sulfonic acid, a substituted organic sulfonic acid salt, a substituted organic carboxylic acid, a substituted organic carboxylic acid salt, an organic carboxylic ester, an organic amine groups, and combinations thereof; wherein, at least four of them are hydrogen atoms.

2. The Chemical Mechanical Polishing composition of Claim 1, wherein the composition further comprises a biocide and/or a pH adjuster.

3. The Chemical Mechanical Polishing composition of Claim 1 or Claim 2, wherein
the abrasive particles range from 0.05 wt.% to 10 wt.% and have a mean particle size ranging from 5nm to 500nm;
the chemical additive ranges from 0.01 wt.% to 20.0% wt.% or 0.05 wt.% to 5% wt.%; and
the composition has a pH of 3 to 10.

4. The Chemical Mechanical Polishing composition of any preceding claim, wherein the abrasive particles have changes of mean particle size MPS(nm) and D99(nm) ≤ 5.0% over shelf time of ≥ 30 days at a temperature ranging from 20 to 60 °C; or have changes of mean particle size MPS(nm) and D99(nm) ≤ 3.0% over shelf time of ≥ 30 days at a temperature ranging from 20 to 60 °C; wherein D99(nm) is a particle size that 99 wt.% of the particles fall on and under.

5. The Chemical Mechanical Polishing composition of any preceding claim wherein the abrasive particles are ceria coated colloidal silica particles.

6. The Chemical Mechanical Polishing composition of any preceding claim wherein the chemical additive has at least four hydroxyl functional groups, preferably at least six hydroxyl functional groups in its molecular structure.

7. The Chemical Mechanical Polishing composition of any preceding claim, wherein the chemical additive has a molecular structure as shown in (a) wherein least one R in the group of R1 to R5 is a polyol molecular subunit having the structure shown in (b) and each of the other Rs in the group of R1 to R5 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

8. The Chemical Mechanical Polishing composition of Claim 7, wherein the chemical additive is selected from 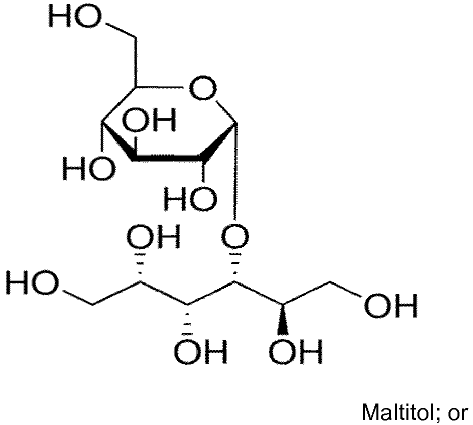 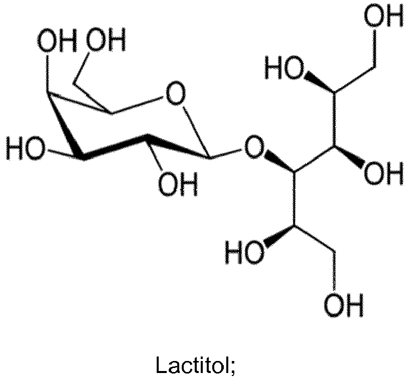 the solvent is deionized (DI) water; and
the abrasive particles have changes of mean particle size MPS(nm) and D99(nm) ≤ 2.0%.

9. The Chemical Mechanical Polishing(CMP) composition of any preceding claim,
wherein
the chemical additive has a molecular structure as shown in (a) wherein at least one R in the group of R1 to R5 is a polyol molecular unit having the structure shown in (b), at least one R in the group of R1 to R5 is a six-member ring polyol as shown in (c), and each of the other Rs in the group of R1 to R5 is independently selected from the group consisting of hydrogen, alkyl, alkoxy, an organic group with one or more hydroxyl groups, a substituted organic sulfonic acid or salt, a substituted organic carboxylic acid or salt, an organic carboxylic ester, an organic amine, and combinations thereof.

10. The Chemical Mechanical Polishing composition of Claim 9, wherein
the chemical additive is : 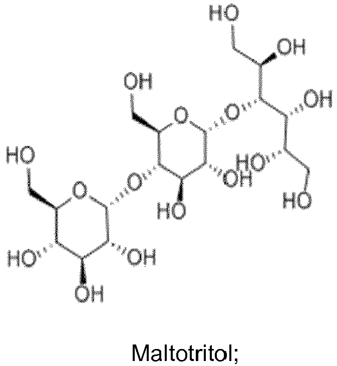 and the solvent is deionized (DI) water, and
the abrasive particles have changes of mean particle size MPS(nm) and D99(nm) ≤ 2.0%.

11. The Chemical Mechanical Polishing composition of any preceding claim, wherein the chemical additive is selected from the group comprising maltitol, lactitol, maltotritol, ribitol, D-sorbitol, mannitol, dulcitol, iditol, D- (-)-Fructose, sorbitan, sucrose, Inositol, glucose, D-arabinose, L-arabinose, L-mannose, D-mannose, L-mannose, meso-erythritol, ribose, beta-lactose, and combinations thereof;
preferably selected from the group comprising maltitol, lactitol, maltotritol, D-sorbitol, mannitol, dulcitol, iditol, D- (-)-Fructose, sucrose, Inositol, glucose, L-mannose, D-mannose, beta-lactose, and combinations thereof;
more preferably selected from the group consisting of maltitol, lactitol, maltotritol, D-sorbitol, mannitol, dulcitol, D- (-)-Fructose, beta-lactose, and combinations thereof.

12. The chemical mechanical polishing composition of any preceding claim, wherein the composition comprises one selected from the group consisting of from 0.0001 wt.% to 0.05 wt.% of the biocide having active ingredient selected from the group consisting of 5-chloro-2-methyl-4-isothiazolin-3-one, 2-methyl- 4-isothiazolin-3-one,and combinations thereof; from 0 wt.% to 1 wt.% of the pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydroxide, potassium hydroxide, ammonium hydroxide, tetraalkyl ammonium hydroxide, organic quaternary ammonium hydroxide compounds, organic amines, and combinations thereof for alkaline pH conditions; and combinations thereof.

13. A method of chemical mechanical polishing a semiconductor substrate having at least one surface comprising a silicon oxide film, the method comprising
(a) providing the semiconductor substrate;
(b) providing a polishing pad;
(c) providing a chemical mechanical polishing composition as claimed in any one of claims 1 to 12;
(d) contacting the at least one surface of the semiconductor substrate comprising the silicon oxide film with the polishing pad and the chemical mechanical polishing composition; and
(e) polishing the least one surface comprising the silicon oxide film;
wherein the silicon oxide film is selected from the group consisting of Chemical vapor deposition , Plasma Enhance CVD , High Density Deposition CVD, spin on , flowable CVD , carbon doped , and nitrogen doped silicon oxide films, and combinations thereof.

14. The method of claim 13; wherein the ratio of oxide trench dishing rate (Å/min.) vs the blanket HDP film removal rate (Å/min.) is ≤ 0.1

15. The method of claim 13 or 14, wherein the semiconductor substrate further comprises a silicon nitride surface; and wherein the method provides a removal selectivity of silicon oxide: silicon nitride of ≥20.

16. A system for chemical mechanical polishing a semiconductor substrate having at least one surface comprising a silicon oxide film, the system comprising:
a. the semiconductor substrate;
b. a polishing pad; and
c. a chemical mechanical polishing composition as claimed in any one of claims 1 to 12;
wherein
the silicon oxide film is selected from the group consisting of Chemical vapor deposition, Plasma Enhance CVD, High Density Deposition CVD, spin on, flowable CVD, carbon doped, and nitrogen doped silicon oxide films, and combinations thereof; and
in use of the system the at least one surface comprising the silicon oxide film is placed in contact with the polishing pad and the chemical mechanical polishing composition.
